(19) Europäisches Patentamt
European Patent Office
Office européen des brevets

(11) **EP 4 800 744 A1**

(12) **EUROPEAN PATENT APPLICATION**
published in accordance with Art. 153(4) EPC

(43) Date of publication:
**02.09.2026 Bulletin 2026/36**

(21) Application number: **24897600.3**

(22) Date of filing: **27.11.2024**

(51) International Patent Classification (IPC):
***H01L 21/60*** *(2006.01)*

(52) Cooperative Patent Classification (CPC):
**C22C 21/00; C22C 21/02; C22F 1/00; C22F 1/04; C22F 1/043; H10W 72/071**

(86) International application number:
**PCT/JP2024/042021**

(87) International publication number:
**WO 2025/115916 (05.06.2025 Gazette 2025/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:
**27.11.2023 PCT/JP2023/042366**
**27.11.2023 PCT/JP2023/042369**
**27.11.2023 PCT/JP2023/042371**
**27.11.2023 PCT/JP2023/042373**
**27.11.2023 PCT/JP2023/042374**
**04.06.2024 PCT/JP2024/020313**
**04.06.2024 PCT/JP2024/020314**

(71) Applicants:
- **NIPPON STEEL CHEMICAL & MATERIAL CO., LTD.**
**Tokyo 103-0027 (JP)**
- **Nippon Micrometal Corporation**
**Iruma-shi**
**Saitama 358-0032 (JP)**

(72) Inventors:
- **UNO, Tomohiro**
**Tokyo 100-8071 (JP)**
- **ODA, Daizo**
**Iruma-shi, Saitama 358-0032 (JP)**
- **ETO, Motoki**
**Iruma-shi, Saitama 358-0032 (JP)**

(74) Representative: **Grünecker Patent- und Rechtsanwälte**
**PartG mbB**
**Leopoldstraße 4**
**80802 München (DE)**

# (54) AL BONDING WIRE OR AL BONDING RIBBON

(57) To provide an Al bonding wire or an Al bonding ribbon that exhibits favorable temperature cycle reliability and favorable 1st bonding strength even in a temperature cycle test at a high temperature, which is required for next-generation SiC power semiconductor devices. The Al bonding wire or the Al bonding ribbon contains 3.0% by mass or more and 20.0% by mass or less of Si, wherein, when a Si concentration (atom%) in a depth direction from a surface of the Al bonding wire or the Al bonding ribbon is measured by X-ray photoelectron spectroscopy (XPS), a ratio Ca/Cb between an average concentration Ca of a Si element in a region a at a depth equal to or larger than 5 nm and equal to or smaller than 50 nm from the surface and an average concentration Cb of the Si element in a region b at a depth equal to or larger than 800 nm and equal to or smaller than 1200 nm from the surface is equal to or larger than 0.03 and equal to or smaller than 0.5.



Processed by Luminess, 75001 PARIS (FR)

## Description

### TECHNICAL FIELD

The present invention relates to an Al bonding wire or an Al bonding ribbon.

### BACKGROUND ART

In a semiconductor device, electrodes formed on a semiconductor chip are connected with a lead frame or electrodes on a substrate via a bonding wire (wire material) or a bonding ribbon (bar material). In a power semiconductor device, a bonding wire or a bonding ribbon mainly made with aluminum (Al) is used. A wire diameter of the Al bonding wire mainly falls within a range from 100 μm to 600 μm. A width of the Al bonding ribbon mainly falls within a range from 100 μm to 3000 μm, and a thickness thereof falls within a range from 50 μm to 600 μm. Herein, the Al bonding wire and the Al bonding ribbon are collectively referred to as an Al connection material.

In the power semiconductor device, silicon (Si) is often used as a material of a semiconductor chip, and an Al-Si alloy or an Al-Cu alloy is often used as a material of the electrode formed on the semiconductor chip. Moreover, power semiconductor devices using the Al bonding wire or the Al bonding ribbon are often used as large power equipment such as air conditioners and photovoltaic power generation systems, or as vehicle-mounted semiconductor devices.

A bonding method for the Al bonding wire or the Al bonding ribbon includes 1st bonding with the electrode on the semiconductor chip and 2nd bonding with the lead frame or the electrode on the substrate, and wedge bonding is used for both of them. The wedge bonding is a method for applying ultrasonic vibrations and loads to the Al bonding wire or the Al bonding ribbon via a jig (tool) made of metal, breaking surface oxide films of the Al bonding wire or the Al bonding ribbon and an electrode material to expose new surfaces, and performing solid phase diffusion bonding. This connection method is characterized in that the connection material is connected in a solid phase state without being melted, which is a bonding technique different from a welding technique of melting the connection material.

A next-generation power semiconductor device is required to stably operate for a long time as compared with a general-purpose power semiconductor device. The power semiconductor device operates while repeatedly turning on and off a current. When a current is supplied to a semiconductor chip made of Si via the Al bonding wire or the Al bonding ribbon, a temperature of a 1st bonding part rises. On the other hand, when supply of the current is stopped, the temperature of the 1st bonding part falls. In this way, the temperature of the 1st bonding part repeatedly rises and falls at the time when the power semiconductor operates. Accordingly, thermal stress, which is caused by a thermal expansion difference between the Al bonding wire or the Al bonding ribbon and the semiconductor chip, is repeatedly applied to the 1st bonding part. In a case of using the Al bonding wire or the Al bonding ribbon made only of high-purity Al, the Al bonding wire or the Al bonding ribbon is broken in a relatively short time due to thermal stress, so that it has been difficult to satisfy performance required for the next-generation power semiconductor device. Thus, in the next-generation power semiconductor device, it is required to improve a lifetime of wire (or ribbon) bond accompanying a temperature rise and a temperature fall of the 1st bonding part (hereinafter, also referred to as "temperature cycle reliability").

In response to the requirement for the temperature cycle reliability, there has been developed an Al bonding wire focused on improvement in mechanical strength. As a method for improving a mechanical characteristic of the Al bonding wire, there has been developed a method for adding a specific element to Al.

Patent Literature 1 discloses a bonding wire made of an Al alloy containing at least magnesium (Mg) and silicon (Si), in which a total content of Mg and Si is equal to or larger than 0.03% by mass and equal to or smaller than 0.3% by mass. This Patent Literature discloses that lowering of bonding strength of the 1st bonding part is delayed in a thermal cycle test in a temperature range from 70°C to 120°C due to a high-strengthening effect exhibited by solid-solution strengthening of Mg or Si, and an effect of suppressing crack development exhibited by precipitated magnesium silicide ($Mg_2Si$).

Patent Literature 2 discloses a bonding wire made of an alloy containing 0.01 to 0.2% by mass of iron (Fe), 1 to 20 mass ppm of silicon (Si), and Al having purity of 99.997% by mass or more as a balance, in which a solid solution amount of Fe is 0.01 to 0.06%, a precipitation amount of Fe is 7 times or less the Fe solid solution amount, and the bonding wire has a fine structure having an average crystal grain size of 6 to 12 μm. This Patent Literature discloses that it is possible to suppress lowering of bonding strength of a 1st bonding part in a thermal shock test within a temperature range from -50°C to 200°C by uniformly dispersing intermetallic compound particles of Fe and Al in Al to improve mechanical strength of a matrix and further refining recrystallized grains.

Patent Literature 3 discloses a bonding wire made by melting an Al-Si alloy containing 0.1 to 5% by mass of silicon (Si), and Al and impurities as a balance, and jetting and rapidly cooling it to be formed in a thin line. This Patent Literature discloses that mechanical strength is improved by rapidly cooling the melted Al-Si alloy to finely and uniformly disperse Si.

### RELATED ART REFERENCE

**Patent Literature**

Patent Literature 1: Japanese Patent Application Laid-open No. 2014-131010
Patent Literature 2: Japanese Patent Application Laid-open No. 2014-129578
Patent Literature 3: Japanese Patent Application Laid-open No. S59-57440

## SUMMARY OF INVENTION

## PROBLEM TO BE SOLVED BY THE INVENTION

As described above, the next-generation power semiconductor device is required to be able to withstand a longer-time use as compared with a general-purpose power semiconductor device. The temperature of the 1st bonding part repeatedly rises and falls at the time when the power semiconductor device operates. As a result, because the Al bonding wire or the Al bonding ribbon has a coefficient of linear thermal expansion larger than that of the semiconductor chip, there has been a case in which thermal stress is caused due to a difference between coefficients of linear thermal expansion thereof (eventually, a difference in linear thermal expansion thereof) at the 1st bonding part, which finally causes fatigue breakdown of the Al bonding wire or the Al bonding ribbon. A temperature cycle test is one of the tests for evaluating, in an accelerated manner, a lifetime of wire (or ribbon) bond accompanying a temperature rise and a temperature fall of the 1st bonding part (temperature cycle reliability). The Al bonding wire or the Al bonding ribbon used for the next-generation power semiconductor device is required to exhibit excellent temperature cycle reliability in the temperature cycle test.

In the next-generation power semiconductor device that replaces a silicon (Si) power semiconductor device, which has been mainstream, use of silicon carbide (SiC) having high heat resistance is predicted to advance. In a connection for a SiC power semiconductor device, temperature cycle reliability under a more severe condition than a current condition is required. For example, while temperature cycle reliability in a temperature range from -40°C to 150°C is required for the Si power semiconductor device, temperature cycle reliability in a temperature range from -40°C to 175°C, as a more severe condition, is required for the SiC power semiconductor device.

Furthermore, in the next-generation SiC power semiconductor device that is used at a high output by utilizing heat resistance of SiC, it is required to exhibit favorable temperature cycle reliability even under a severe test condition in which an upper limit temperature of the temperature cycle test is increased to 185°C. When the upper limit temperature of the temperature cycle test further increases from 175°C to 185°C, a temperature difference in a temperature cycle increases by 10°C, a difference in linear thermal expansion described above at a bonding part of the Al bonding wire or the Al bonding ribbon is increased, and acceleration of fatigue breakdown becomes a problem.

When bonding is performed, if a bonding defect such as peeling of the Al bonding wire or the Al bonding ribbon from an electrode occurs, it leads to a product defect or lowering of manufacturing yield, so that it is required to obtain favorable bonding strength at each bonding part. In this regard, in the 1st bonding part, when ultrasonic vibrations and loads are strongly applied to obtain favorable bonding strength, the semiconductor chip may be damaged. In particular, in a case of using the Al bonding wire or the Al bonding ribbon that is highly strengthened by adding Si and the like thereto, the semiconductor chip is likely to be damaged at the time of the 1st bonding due to hardness thereof, and when ultrasonic vibrations or loads are adjusted in order to reduce such damage, sufficient bonding strength of the 1st bonding part (hereinafter, also simply referred to as "1st bonding strength") cannot be obtained in some cases because a bonding area cannot be stably secured due to high deformation resistance, instability in a deformation direction, or the like. These problems at the time of initial bonding of the 1st bonding part eventually become factors of a reduction or instability in temperature cycle reliability, and therefore constitute an obstacle to practical use of the Al bonding wire or the Al bonding ribbon that is highly strengthened by adding Si and the like thereto.

The present invention has been made in view of the above problem, and aims at providing an Al bonding wire or an Al bonding ribbon that exhibits favorable temperature cycle reliability and favorable 1st bonding strength even in a temperature cycle test at a high temperature, which is required for next-generation SiC power semiconductor devices.

## MEANS FOR SOLVING PROBLEM

As a result of earnest investigation as to the problem described above, the present inventors have found that the problem described above can be solved by an Al bonding wire or an Al bonding ribbon containing 3.0% by mass or more and 20.0% by mass or less of Si, wherein, when Si concentration (atom%) in a depth direction from a surface of the Al bonding wire or the Al bonding ribbon is measured by X-ray photoelectron spectroscopy (XPS), a ratio Ca/Cb between an average concentration Ca of a Si element in a region a at a depth equal to or larger than 5 nm and equal to or smaller than 50

nm from the surface and an average concentration Cb of the Si element in a region b at a depth equal to or larger than 800 nm and equal to or smaller than 1200 nm from the surface is equal to or larger than 0.03 and equal to or smaller than 0.5, and have further investigated the problem based on such knowledge to complete the present invention.

That is, the present invention includes the following content.

<1> An Al bonding wire or an Al bonding ribbon containing 3.0% by mass or more and 20.0% by mass or less of Si, wherein
when a Si concentration (atom%) in a depth direction from a surface of the Al bonding wire or the Al bonding ribbon is measured by X-ray photoelectron spectroscopy (XPS), a ratio Ca/Cb between an average concentration Ca of a Si element in a region a at a depth equal to or larger than 5 nm and equal to or smaller than 50 nm from the surface and an average concentration Cb of the Si element in a region b at a depth equal to or larger than 800 nm and equal to or smaller than 1200 nm from the surface is equal to or larger than 0.03 and equal to or smaller than 0.5.

<2> The Al bonding wire or the Al bonding ribbon according to <1>, wherein an average diameter of a Si phase in an L cross-section (cross section in a center axis direction including a center axis) of the Al bonding wire or the Al bonding ribbon is equal to or larger than 0.8 μm and equal to or smaller than 4 μm.

<3> The Al bonding wire or the Al bonding ribbon according to <1> or <2>, wherein an average concentration Cf of the Si element in a region f at a depth equal to or larger than 5 nm and equal to or smaller than 30 nm from the surface is equal to or larger than 0.1 atom% and equal to or smaller than 4 atom%.

<4> The Al bonding wire or the Al bonding ribbon according to any one of <1> to <3>, wherein, when a crystal orientation of an Al phase in the L cross-section (cross section in the center axis direction including the center axis) of the Al bonding wire or the Al bonding ribbon is measured, an orientation ratio of a <100> crystal orientation angled at 15° or less to a direction parallel to the center axis (RD direction) is equal to or larger than 15% and equal to or smaller than 50%.

<5> The Al bonding wire or the Al bonding ribbon according to any one of <1> to <4>, further containing 10 mass ppm or more and 800 mass ppm or less of one or more of Sr, Na, P, and B in total.

<6> The Al bonding wire or the Al bonding ribbon according to any one of <1> to <5>, further containing 100 mass ppm or more and 2000 mass ppm or less of one or more of Ni, Ti, Fe, Zn, and Mg in total.

<7> The Al bonding wire or the Al bonding ribbon according to any one of <1> to <6>, wherein a total concentration of elements other than Al, Si, Sr, Na, P, B, Ni, Ti, Fe, Zn, and Mg in the Al bonding wire or the Al bonding ribbon is equal to or smaller than 0.5% by mass.

<8> The Al bonding wire or the Al bonding ribbon according to any one of <2> to <7>, wherein the average diameter of the Si phase is a value measured by using an SEM-EDS-EBSD apparatus.

<9> The Al bonding wire or the Al bonding ribbon according to any one of <4> to <8>, wherein the orientation ratio of a crystal orientation is a value measured by using an SEM-EDS-EBSD apparatus.

<10> The Al bonding wire or the Al bonding ribbon according to any one of <1> to <9>, used for a semiconductor device.

<11> A semiconductor device comprising the Al bonding wire or the Al bonding ribbon according to any one of <1> to <10>.

## EFFECT OF THE INVENTION

According to the present invention, it is possible to provide an Al bonding wire or an Al bonding ribbon that exhibits favorable temperature cycle reliability and favorable 1st bonding strength even in a temperature cycle test at a high temperature, which is required for next-generation SiC power semiconductor devices.

## BRIEF DESCRIPTION OF DRAWINGS

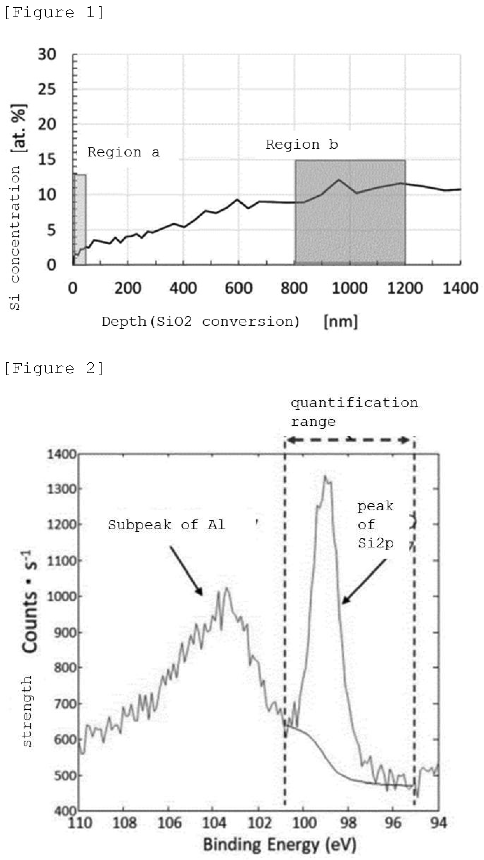

FIG. 1 illustrates an example of a Si concentration profile when Si concentration in a depth direction is measured and evaluated by XPS for an Al bonding wire or an Al bonding wire according to the present invention. This is a profile of the Si concentration in the depth direction assuming that a sum total of metallic Si and metallic Al is 100 atom%.

FIG. 2 illustrates an example of a peak of Si0 valence of Si2p acquired by XPS for the Al bonding wire or the Al bonding ribbon according to the present invention. FIG. 2 is also a diagram for explaining quantification of a Si element based on the peak of Si0 valence of Si2p.

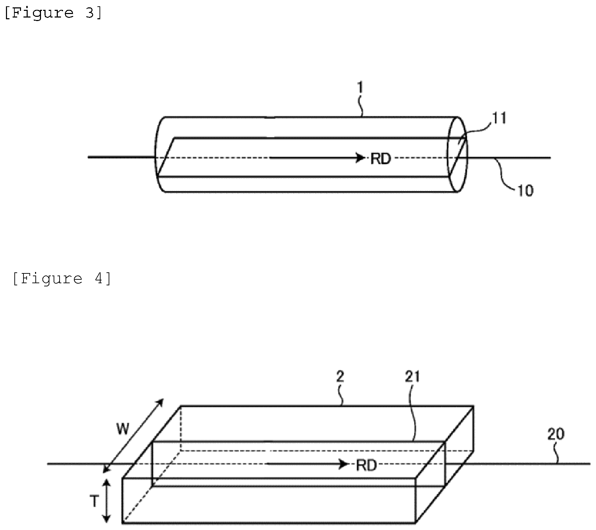

FIG. 3 is a schematic diagram for explaining, regarding the Al bonding wire, a measurement target surface (inspection surface) when measuring a crystal orientation of an Al phase and an average diameter of a Si phase. The measurement target surface is a cross section in a center axis direction including a center axis (L cross-section)

of the Al bonding wire.

FIG. 4 is a schematic diagram for explaining, regarding the Al bonding ribbon, a measurement target surface (inspection surface) when measuring a crystal orientation of an Al phase and an average diameter of a Si phase. The measurement target surface is a cross section in a center axis direction including a center axis (L cross-section) of the Al bonding ribbon.

Description of Embodiments

Hereinafter, the present invention will be described in detail with reference to preferable embodiments thereof. While the drawings may be referred to for description, each of the drawings merely schematically illustrates shapes, sizes, and arrangement of constituent elements to the extent that the invention can be understood. The present invention is not limited to the following embodiments and examples, and may be optionally changed to be implemented without departing from CLAIMS of the present invention and equivalents thereof.

[Al bonding wire or Al bonding ribbon]

An Al bonding wire or an Al bonding ribbon according to the present invention contains 3.0% by mass or more and 20.0% by mass or less of Si, and is characterized in that, when a Si concentration (atom%) in a depth direction from a surface of the Al bonding wire or the Al bonding ribbon is measured by X-ray photoelectron spectroscopy (XPS), a ratio Ca/Cb between an average concentration Ca of a Si element in a region a at a depth equal to or larger than 5 nm and equal to or smaller than 50 nm from the surface and an average concentration Cb of the Si element in a region b at a depth equal to or larger than 800 nm and equal to or smaller than 1200 nm from the surface is equal to or larger than 0.03 and equal to or smaller than 0.5.

As described above, in a case of using an Al bonding wire or an Al bonding ribbon composed only of high-purity Al in a temperature cycle test (hereinafter, also referred to as a "TCT"), there is a problem in that a crack develops at a relatively high speed inside the Al bonding wire or the Al bonding ribbon, and temperature cycle reliability is lowered. It has been confirmed that, by using an Al alloy to which Si is added at a high concentration, thermal expansion of the Al bonding wire or the Al bonding ribbon can be reduced, and temperature cycle reliability can be improved. On the other hand, even in a case of using an Al alloy to which Si is added at a high concentration, sufficient temperature cycle reliability cannot be achieved in some cases in a temperature cycle test at a high temperature that employs a considerably high upper limit temperature (for example, 185°C) (hereinafter, also referred to as a "high-temperature temperature cycle test" or "high-temperature TCT"). As described above, in a next-generation power semiconductor device having high heat resistance, such as a SiC power semiconductor device, it is required to exhibit favorable temperature cycle reliability even in a high-temperature temperature cycle test that employs such a severe test condition, and further improvement in temperature cycle reliability is required.

In the high-temperature temperature cycle test, it has been confirmed that occurrence of a defect is accelerated in the vicinity of a bonding interface at an initial stage of 1st bonding of the Al bonding wire or the Al bonding ribbon. Regarding a method for bonding the Al bonding wire or the Al bonding ribbon, diffusion at the bonding interface is suppressed because bonding is normally performed at room temperature, and an influence of a surface state of the Al bonding wire or the Al bonding ribbon on a bonding property becomes strong. In the high-temperature temperature cycle test, a difference in linear thermal expansion at the bonding part is increased due to an increase in a temperature difference of a temperature cycle, and thermal distortion is concentrated in the vicinity of the bonding interface from an early stage, so that the surface state of the Al bonding wire or the Al bonding ribbon may become a factor that accelerates crack development. When a crack at the bonding interface grows or a crack develops inside the Al bonding wire or the Al bonding ribbon, temperature cycle reliability is lowered at an earlier stage.

The present inventors have found that modification of the surface of the Al bonding wire or the Al bonding ribbon is effective with respect to crack development at the bonding interface, which becomes a factor of reliability deterioration in the high-temperature temperature cycle test. In the Al bonding wire or the Al bonding ribbon made of an Al alloy to which Si is added at a high concentration (hereinafter, also referred to as a "high-concentration Al-Si alloy"), an influence of a surface state thereof on temperature cycle reliability is further increased. That is, regarding the Al bonding wire or the Al bonding ribbon made of a high-concentration Al-Si alloy, it has been found that, by providing a predetermined inclination (gradient) in Si concentration in a depth direction in a region from the surface thereof to a certain depth, specifically, by providing an inclination of the Si concentration such that the ratio Ca/Cb between the average concentration Ca of the Si element in the region a at a depth equal to or larger than 5 nm and equal to or smaller than 50 nm from the surface and the average concentration Cb of the Si element in the region b at a depth equal to or larger than 800 nm and equal to or smaller than 1200 nm from the surface is equal to or larger than 0.03 and equal to or smaller than 0.5, crack development in the vicinity of the bonding interface can be suppressed even in the high-temperature temperature cycle test, and favorable temperature cycle reliability can be achieved. It has also been found that, by modifying the surface of the Al bonding wire or

the Al bonding ribbon made of a high-concentration Al-Si alloy to have the predetermined inclination of the Si concentration described above, the problem at the time of initial bonding of the 1st bonding part can be solved, and favorable 1st bonding strength can be achieved.

A reason why the Al bonding wire or the Al bonding ribbon according to the present invention exhibits favorable temperature cycle reliability and favorable 1st bonding strength even in the high-temperature temperature cycle test is estimated as follows.

Regarding the Al bonding wire or the Al bonding ribbon made of a high-concentration Al-Si alloy, by providing a predetermined inclination in the Si concentration in the depth direction in a region from the surface thereof to a certain depth, that is, by providing an inclination of the Si concentration such that the Si concentration in the vicinity of the surface is low, the Si concentration in a deep part is high, and a condition of the ratio Ca/Cb described above is satisfied, a deformation property of the surface of the Al bonding wire or the Al bonding ribbon when ultrasonic vibrations or loads are applied at the time of bonding is improved, destruction of a surface oxide film is accelerated, and diffusion of Al atoms at the bonding interface is accelerated. As a result, an increase in bonding strength and stabilization of a deformation shape progress, which is considered to contribute to maintaining strong bonding at the bonding interface in the temperature cycle test. As a factor that causes these actions and effects, it is considered that, in a region from the surface of the Al bonding wire or the Al bonding ribbon to a certain depth, a surface side is relatively softened and purified to a higher degree (from a viewpoint of the Al concentration) than the deep part. It is considered that a remarkable effect of achieving favorable temperature cycle reliability even in the high-temperature temperature cycle test in which an upper limit temperature is 185°C is obtained by a synergistic action of a control effect of an interface due to a concentration inclination in which the Si concentration on the surface side is low to a certain degree, contribution to reduction of a difference in coefficient of linear thermal expansion due to the Si phase in an inner part described later, and a reduction effect of thermal stress resulting therefrom.

As described above, it is estimated that the Al bonding wire or the Al bonding ribbon according to the present invention can exhibit favorable temperature cycle reliability and favorable 1st bonding strength even in the high-temperature temperature cycle test as described above as a result of modifying the surface to have a predetermined inclination in the Si concentration in the depth direction in a region from the surface thereof to a certain depth.

The following describes a configuration of the Al bonding wire or the Al bonding ribbon according to the present invention in detail. Hereinafter, the Al bonding wire or the Al bonding ribbon are collectively referred to as an "Al bonding wire or the like" or a "wire or the like".

-Si concentration-

The Al bonding wire or the Al bonding ribbon according to the present invention contains 3.0% by mass or more and 20.0% by mass or less of Si.

A Si concentration in a range equal to or larger than 3.0% by mass and equal to or smaller than 20.0% by mass is useful in reducing thermal distortion of the bonding part and improving a temperature cycle characteristic. Specifically, when the Si concentration is equal to or larger than 3.0% by mass, an improvement effect in temperature cycle reliability can be increased even in the high-temperature temperature cycle test. In addition, regarding an upper limit of the Si concentration, along with progress and optimization of equipment and conditions used for manufacturing and bonding of a wire or the like, higher values have become allowable while suppressing defects such as wire breakage during processing, deterioration of surface properties, reduction in initial bonding strength due to hardening, and damage to the semiconductor chip; when the Si concentration is equal to or smaller than 20.0% by mass, these defects can be favorably suppressed while achieving intended temperature cycle reliability. From a viewpoint of obtaining favorable temperature cycle reliability even in the high-temperature temperature cycle test, the concentration of Si in the Al bonding wire or the like according to the present invention is equal to or larger than 3.0% by mass, preferably equal to or larger than 3.5% by mass, more preferably equal to or larger than 4.0% by mass, even more preferably equal to or larger than 4.2% by mass, equal to or larger than 4.4% by mass, equal to or larger than 4.5% by mass, equal to or larger than 4.6% by mass, equal to or larger than 4.8% by mass, or equal to or larger than 5.0% by mass. In addition, from a viewpoint of achieving intended temperature cycle reliability while favorably suppressing defects such as reduction in initial bonding strength due to hardening and damage to the semiconductor chip, the concentration of Si in the Al bonding wire or the like according to the present invention is equal to or smaller than 20.0% by mass, and preferably equal to or smaller than 19.0% by mass, equal to or smaller than 18.0% by mass, equal to or smaller than 17.0% by mass, equal to or smaller than 16.0% by mass, equal to or smaller than 15.0% by mass, equal to or smaller than 14.5% by mass, equal to or smaller than 14.0% by mass, equal to or smaller than 13.5% by mass, equal to or smaller than 13.0% by mass, or equal to or smaller than 12.5% by mass. Furthermore, when hardness of the Al bonding wire or the like is high, the semiconductor chip tends to be easily damaged at the time of 1st bonding depending on bonding conditions of ultrasonic vibrations and loads. From a viewpoint of obtaining favorable bonding strength under a wider range of bonding conditions, the Si concentration in the Al bonding wire or the like according to the present invention is more preferably equal to or smaller than 12.0% by mass, still more

preferably equal to or smaller than 11.5% by mass or equal to or smaller than 11.0% by mass, and particularly preferably equal to or smaller than 10.8% by mass, equal to or smaller than 10.6% by mass, equal to or smaller than 10.5% by mass, equal to or smaller than 10.4% by mass, equal to or smaller than 10.2% by mass, or equal to or smaller than 10.0% by mass.

For concentration analysis of elements contained in the Al bonding wire or the like according to the present invention, for example, an Inductively Coupled Plasma (ICP) emission spectrophotometer or an ICP mass spectrometer can be used. In a case in which elements derived from contaminants in the air, such as oxygen or carbon, are adsorbed on a surface of the Al bonding wire or the like, it is effective to clean it with acid or alkali depending on adsorbed substances before performing analysis.

The Al bonding wire or the like according to the present invention contains 3.0% by mass or more and 20.0% by mass or less of Si, and is constituted of the Al phase in which Si is dissolved in Al as a solid solution and the Si phase formed by crystallization or precipitation of Si. In the Al phase, other additive elements may be dissolved as a solid solution in addition to Si. Moreover, the Si phase is a general term for Si crystallized products and Si precipitates. The Si crystallized product is formed from a solution during solidification, and has a size of about 1 to 25 μm, which is coarse. On the other hand, the Si precipitate is formed from a solid state, and has a small size of about 0.1 μm to several micrometers. The Si phase has a coefficient of linear thermal expansion smaller than that of Al, contributes to reduction of a difference in coefficient of linear thermal expansion between the Al bonding wire or the like and the semiconductor chip, and can reduce thermal stress, thereby having an effect of improving temperature cycle reliability.

-Inclination of Si concentration-

In the Al bonding wire or the Al bonding ribbon according to the present invention, when the Si concentration (atom%) in the depth direction from the surface of the Al bonding wire or the Al bonding ribbon is measured by X-ray photoelectron spectroscopy (XPS), the ratio Ca/Cb between the average concentration Ca of the Si element in the region a at a depth equal to or larger than 5 nm and equal to or smaller than 50 nm from the surface and the average concentration Cb of the Si element in the region b at a depth equal to or larger than 800 nm and equal to or smaller than 1200 nm from the surface is equal to or larger than 0.03 and equal to or smaller than 0.5.

In the present invention, the inclination of the Si concentration in the depth direction is measured and evaluated by X-ray photoelectron spectroscopy (XPS). Regarding XPS, quantitative analysis in the depth direction from the surface of the Al bonding wire or the like can be accurately performed by using a sputtering operation of the apparatus. By using XPS, the Si element having a low concentration of about 0.1 atom% can be accurately measured.

In the present invention, in measuring and evaluating the inclination of the Si concentration in the depth direction by XPS, the Si concentration is obtained assuming that a sum total of the metallic Si and the metallic Al is 100 atom%.

FIG. 1 illustrates an example of a Si concentration profile when the Si concentration in the depth direction is measured and evaluated by XPS for the Al bonding wire or the Al bonding ribbon according to the present invention. In a region from the surface to a certain depth, a predetermined inclination in the Si concentration in the depth direction is confirmed, that is, the concentration inclination is confirmed such that the Si concentration on the surface side is low, the Si concentration in a deep part is high, and the Si concentration gradually increases in the depth direction.

Regarding a form of Si detected by XPS, solid-solution Si in the Al phase, Si particles (precipitation and crystallization), and intermetallic compounds containing Si are targeted. Although origins of Si to be detected may be different as described above, without distinguishing between them, whether a predetermined inclination of the Si concentration (the ratio Ca/Cb described above) is satisfied is determined based on the Si concentration detected by XPS. It is an important feature of the present invention that the intended problems and effects can be solved and achieved by adjusting the inclination of the Si concentration in the depth direction measured by XPS as described above.

As the Si concentration, a concentration measured by XPS and obtained from a peak of detected metallic Si (Si having a valence of zero) is used. Since peaks of metallic Si and Si oxide are detected at different energies, a concentration of metallic Si can be obtained separately from the Si oxide. Temperature cycle reliability and 1st bonding strength are influenced by the concentration of metallic Si in a surface region of the Al bonding wire or the Al bonding ribbon. It has been confirmed that the Si oxide is rarely formed on the surface of the Al bonding wire or the Al bonding ribbon or on a surface of the Si particle, and even if it is formed, the Si oxide is considerably thin, so that the Si oxide has little influence on temperature cycle reliability or 1st bonding strength, and is excluded from an analysis target in determination of the concentration inclination of the present invention.

In the present invention, when the Si concentration in the depth direction from the surface of the Al bonding wire or the Al bonding ribbon is measured by XPS, the ratio Ca/Cb between the average concentration Ca of the Si element in the region a at a depth equal to or larger than 5 nm and equal to or smaller than 50 nm from the surface and the average concentration Cb of the Si element in the region b at a depth equal to or larger than 800 nm and equal to or smaller than 1200 nm from the surface falls within a range equal to or larger than 0.03 and equal to or smaller than 0.5.

Herein, a reason why the average concentration Ca of the Si element in the region a at a depth equal to or larger than 5 nm and equal to or smaller than 50 nm from the surface is used is that the region a is deformed by application of

ultrasonic vibrations and loads at the time of bonding and has a large influence on performance of the bonding interface. Analysis of an outermost surface region at a depth smaller than 5 nm from the surface is excluded from an analysis range because it is easily influenced by surface contamination and variation in the Si concentration measured by XPS becomes large. In addition, a region at a depth exceeding 50 nm from the surface is excluded from the analysis range because it has little influence on the bonding interface. In addition, a reason why the average concentration Cb of the Si element in the region b at a depth equal to or larger than 800 nm and equal to or smaller than 1200 nm from the surface is used is that the region b is an appropriate depth range for obtaining the Si concentration representing an internal composition of the Al bonding wire or the Al bonding ribbon, in consideration of the facts that the Si concentration is substantially stable and that analysis efficiency can be ensured while avoiding a long sputtering time at the time of measurement. Both for the region a at a depth equal to or larger than 5 nm and equal to or smaller than 50 nm from the surface and for the region b at a depth equal to or larger than 800 nm and equal to or smaller than 1200 nm from the surface, by using average concentrations of the Si element (Ca and Cb) and evaluating the inclination of the Si concentration based on the ratio Ca/Cb, an influence of variation in the Si concentration is minimized. Furthermore, using the average concentration Cb of the Si element in the region b inside the sample measured by XPS and calculating the ratio Ca/Cb by comparison with the average concentration Ca of the Si element in the region a on a surface of the sample measured by the same method are effective for accurately determining the inclination of the Si concentration in the depth direction. This enables accurate determination of whether the inclination in Si concentration in the depth direction has been successfully achieved, making it suitable for realizing Al bonding wire or Al bonding ribbon with good 1st bonding strength accompanying favorable reliability in the high-temperature temperature cycle test at a high temperature.

When the ratio Ca/Cb which is a relative ratio of the Si concentration between the vicinity of the surface and the deep part falls within a range equal to or larger than 0.03 and equal to or smaller than 0.5, it is possible to achieve an Al bonding wire or an Al bonding ribbon that exhibits favorable temperature cycle reliability and favorable 1st bonding strength even in the high-temperature temperature cycle test thanks to improving a deformation property of the surface, acceleration of destruction of a surface oxide film, acceleration of diffusion of Al atoms at the bonding interface etc. in the Al bonding wire or the Al bonding ribbon which ultrasonic vibrations or loads are applied at the time of bonding. From a viewpoint of being able to achieve the Al bonding wire or the Al bonding ribbon that exhibits further favorable temperature cycle reliability and further favorable 1st bonding strength even in the high-temperature temperature cycle test, the ratio Ca/Cb is preferably equal to or smaller than 0.48, more preferably equal to or smaller than 0.46, and still more preferably equal to or smaller than 0.45, equal to or smaller than 0.44, equal to or smaller than 0.42, or equal to or smaller than 0.4. A lower limit of the ratio Ca/Cb can solve and achieve the intended problems and effects when it is equal to or larger than 0.03, but may be, for example, equal to or larger than 0.04, equal to or larger than 0.05, equal to or larger than 0.06, equal to or larger than 0.08, or equal to or larger than 0.1. In particular, when the ratio Ca/Cb is equal to or smaller than 0.45, it is preferable because remarkably favorable temperature cycle reliability can be achieved and further favorable 1st bonding strength can be easily achieved even in the high-temperature temperature cycle test.

In the present invention, by controlling the ratio Ca/Cb described above, which is a relative ratio of the Si concentration between the vicinity of the surface and the deep part, to fall within a certain range equal to or larger than 0.03 and equal to or smaller than 0.5, the present inventors have succeeded in achieving the Al bonding wire or the Al bonding ribbon that exhibits favorable temperature cycle reliability and favorable 1st bonding strength even in the high-temperature temperature cycle test, and have found that controlling the ratio Ca/Cb to fall within the certain range is effective and important for solving the problem.

In the present invention, the Si concentration in the depth direction in a region from the surface of the Al bonding wire or the Al bonding ribbon to a certain depth can be measured by performing composition analysis by XPS while digging from the surface of the Al bonding wire or the Al bonding ribbon in the depth direction (a direction toward a center of the wire or the like) by Ar sputtering. Specifically, by repeating (1) sputtering with Ar and (2) composition analysis of the surface after the sputtering, a concentration change of the Si element in the depth (center) direction from the surface of the Al bonding wire or the Al bonding ribbon (what is called a concentration profile in the depth direction) can be acquired.

In one embodiment, the Si concentration in the depth direction in a region from the surface of the Al bonding wire or the Al bonding ribbon of the present invention to a certain depth is measured through procedures from (1) to (4) as follows.

(1) Preparation of measurement sample

A sample of the Al bonding wire or the Al bonding ribbon to be measured is placed on a sample stage. At that time, a position of the sample is adjusted such that a longitudinal direction of the sample becomes a lateral direction on an operation screen of an XPS apparatus. In a case in which the sample is an Al bonding ribbon (having a rectangular or substantially rectangular cross-sectional shape with a width W and a thickness T), the sample is placed such that a direction of the width W is parallel to a surface of the sample stage and a direction of the thickness T is perpendicular to the surface of the sample stage.

(2) Measurement by XPS

In measurement by XPS, a measurement region is selected such that a vicinity of an apex of the sample of the Al bonding wire or the Al bonding ribbon becomes the measurement region while viewing a screen of Scanning X-ray Image (SXI) of the apparatus. Herein, the apex of the sample of the Al bonding wire or the Al bonding ribbon refers to a portion located directly above a center axis of the sample when the sample is observed from directly above. Then, under the following conditions, (1) sputtering with Ar and (2) composition analysis of the surface after the sputtering were repeated, measurement in the depth direction from the surface of the sample was performed, and spectra of Si2p and Al2p were detected. Peaks of the spectra of Si2p and Al2p are detected at positions where energy is about 98.5 to 99.5 eV and 71.5 to 73.0 eV, respectively.

- Measurement apparatus: Versa Probe 3 manufactured by ULVAC-PHI, Inc.
- Ultimate vacuum: about $1 \times 10^{-8}$ Torr
- X-ray source: monochromatic Al (1486.6 eV)
- Measurement region: 100 $\mu$m (sample longitudinal direction) $\times$ 20 $\mu$m (sample circumferential direction), rectangular
- Photoelectron extraction angle: 45 degrees
- Detection depth: several nanometers
- Ar sputtering

  Acceleration voltage; 2 kV
  Sputtering region: $2 \times 2$ mm, rectangular
  Sputtering speed: 9.2 nm/min ($SiO_2$ conversion)

- Analysis pitch in the depth direction: 5 nm pitch (a depth from the surface falls within a range from 0 to 50 nm), 10 nm pitch (a depth from the surface falls within a range from 50 to 200 nm), and 20 nm pitch (a depth from the surface exceeds 200 nm)

As described above, in measurement by XPS, a scale of the sputtering speed and depth can be calculated based on general $SiO_2$ conversion. In consideration of analysis accuracy, a measurement time, workability, and the like, the analysis pitch in the depth direction can be selected such that the pitch is fine at the surface and coarse in the deep part. For example, as described above, the pitch can be set to 5 nm in a range where the depth from the surface is 0 to 50 nm, the pitch can be set to 10 nm in a range where the depth from the surface is 50 to 200 nm, and the pitch can be set to 200 nm in a range where the depth from the surface exceeds 200 nm.

(3) Quantification of Si and Al elements

Based on detected spectra of Si2p and Al2p acquired at respective depth positions in the depth direction from the surface of the sample, quantification of Si and Al elements is performed by the following procedures.

Specifically, quantification of the Si element is performed for a quantification range of energy (about 95.0 to 101.0 eV) that includes a peak of Si0 valence (metallic Si) of Si2p. Depending on the shape of the peak described above, energy values of a low-energy end and a high-energy end were adjusted within the quantification range described above. A background of the quantification range is determined by using Shirley method, and the Si element is quantified based on a peak area obtained by subtracting the background.

FIG. 2 illustrates an example of the peak of Si0 valence of Si2p acquired by XPS for the Al bonding wire or the Al bonding ribbon according to the present invention. The peak of Si0 valence of Si2p is included in a quantification range of about 95.0 to 101.0 eV, and the low-energy end of the peak can be selected within a range from 95 to 96.5 eV and the high-energy end of the peak can be selected within a range from 99.8 to 101.3 eV.

Quantitative analysis of the Al element is performed for a quantification range of energy (about 69.0 to 79.0 eV) that includes a peak of Al0 valence (metallic Al) of Al2p, through a procedure similar to that for quantification of the Si element described above.

(4) Calculation of Si concentration

By using quantitative values of Si and Al elements at respective depth positions in the depth direction from the surface of the sample and relative sensitivity coefficients of the respective elements set in the XPS apparatus, a Si concentration (atom%) is calculated assuming that the sum total of Si and Al at the respective depth positions in the depth direction from the surface of the sample is 100 atom%. C elements influenced by contaminants on the surface of the sample are excluded from the analysis target. An arithmetic mean value of the Si concentration in the region a at a depth

equal to or larger than 5 nm and equal to or smaller than 50 nm from the surface is obtained as the average concentration Ca, an arithmetic mean value of the Si concentration in the region b at a depth equal to or larger than 800 nm and equal to or smaller than 1200 nm from the surface is obtained as the average concentration Cb, and an arithmetic mean value of the Si concentration in a region f at a depth equal to or larger than 5 nm and equal to or smaller than 30 nm from the surface is obtained as an average concentration Cf.

In the present invention, the inclination of the Si concentration in the depth direction and an average concentration of the Si element in the vicinity of the surface (described later) are evaluated based on an average value (arithmetic mean) of respective values obtained by measuring at two or more parts. From a viewpoint of securing objectivity of measurement data, it is preferable that two or more samples are subjected to measurement, the samples being randomly selected from a plurality of samples acquired from the Al bonding wire or the Al bonding ribbon as a measurement target at intervals of 50 cm or more with respect to the center axis direction of the wire or the ribbon. The average concentration Ca, the average concentration Cb, and the average concentration Cf are each defined as an average value (arithmetic mean) of respective values obtained for each sample through the procedures (1) to (4) described above.

-Average concentration of Si element in vicinity of surface-

When the Si concentration (atom%) in the depth direction from the surface of the Al bonding wire or the Al bonding ribbon is measured by XPS, the Al bonding wire or the Al bonding ribbon according to the present invention preferably satisfies a predetermined inclination of the Si concentration (the ratio Ca/Cb described above), and in addition, the average concentration Cf of the Si element in the region f at a depth equal to or larger than 5 nm and equal to or smaller than 30 nm from the surface is preferably equal to or larger than 0.1 atom% and equal to or smaller than 4 atom%.

In addition to satisfying the predetermined inclination of the Si concentration (the ratio Ca/Cb described above), by controlling the average concentration Cf of the Si element in the region f in the vicinity of the surface to fall within the range described above, a lifetime of the Al bonding wire or the Al bonding ribbon (the number of cycles until a defect occurs) can be further improved in the high-temperature temperature cycle test. It is considered that, by suppressing the average concentration Cf to be low within the range described above, it is possible to enable softening in the vicinity of the surface of the Al bonding wire or the like, acceleration of recrystallization, improvement in a deformation property at the time of bonding, formation of a flat bonding interface, and the like, and as a result, the lifetime of the Al bonding wire or the like in the high-temperature temperature cycle test can be further improved. From a viewpoint of being able to further improve the lifetime of the Al bonding wire or the like in the high-temperature temperature cycle test, the average concentration Cf of the Si element in the region f in the vicinity of the surface is more preferably equal to or smaller than 3.8 atom% or equal to or smaller than 3.6 atom%, and still more preferably equal to or smaller than 3.5 atom%, equal to or smaller than 3.4 atom%, equal to or smaller than 3.2 atom%, or equal to or smaller than 3 atom%. A lower limit of the average concentration Cf is preferably equal to or larger than 0.1 atom%, and may be, for example, equal to or larger than 0.12 atom%, equal to or larger than 0.14 atom%, equal to or larger than 0.15 atom%, equal to or larger than 0.16 atom%, equal to or larger than 0.18 atom%, or equal to or larger than 0.2 atom%. Herein, the average concentration Cf of the Si element in the region f in the vicinity of the surface is used because the region f has a large influence on temperature cycle reliability and a lifetime in the high-temperature temperature cycle test.

By controlling the average concentration Cf of the Si element in the vicinity of the surface to be lower than a Si concentration Ct in the entire Al bonding wire or the Al bonding ribbon, the effect of improving the lifetime described above can be further improved. In one embodiment, a ratio Cf/Ct between the surface concentration Cf of the Si element and the Si concentration Ct in the entire Al bonding wire or the Al bonding ribbon preferably falls within a range equal to or larger than 0.03 and equal to or smaller than 0.8. Herein, the Si concentration Ct is based on the Si concentration in the entire Al bonding wire or the Al bonding ribbon measured by using an ICP emission spectrometer or an ICP mass spectrometer. From a viewpoint of achieving further favorable temperature cycle reliability even in the high-temperature temperature cycle test, the ratio Cf/Ct is more preferably equal to or smaller than 0.7, and still more preferably equal to or smaller than 0.6, equal to or smaller than 0.55, or equal to or smaller than 0.5. Also, a lower limit of the ratio Cf/Ct is preferably equal to or larger than 0.03, may be, for example, equal to or larger than 0.04, equal to or larger than 0.05, equal to or larger than 0.06, equal to or larger than 0.08, or equal to or larger than 0.1. By controlling the ratio Cf/Ct to fall within the range described above, it is possible to accelerate deformation in the vicinity of the surface of the Al bonding wire or the Al bonding ribbon when ultrasonic vibrations or loads are applied at the time of bonding and accelerate metallic bonding at the bonding interface. As a result, it is possible to obtain a high effect of improving the lifetime of the Al bonding wire or the Al bonding ribbon in the high-temperature temperature cycle test.

As described above, in the present invention, the inclination of the Si concentration in the depth direction and the concentration of the Si element in the vicinity of the surface are measured and evaluated by XPS. By using XPS, the Si element having a low concentration of about 0.1 atom% can be accurately measured, and it is possible to accurately measure and determine whether conditions of the inclination of the Si concentration in the depth direction and the concentration of the Si element in the vicinity of the surface are met, the conditions being suitable for achieving the Al

bonding wire or the Al bonding ribbon that exhibits favorable temperature cycle reliability and favorable 1st bonding strength in the high-temperature temperature cycle test.

-Average diameter of Si phase in L cross-section-

In the Al bonding wire or the Al bonding ribbon according to the present invention, an average diameter of the Si phase in an L cross-section (a cross section in the center axis direction including a center axis) is preferably equal to or larger than 0.8 μm and equal to or smaller than 4 μm.

Herein, in the present invention, the center axis of the Al bonding wire, the cross section in the center axis direction including the center axis (L cross-section), and a direction parallel to the center axis (RD direction) (described later) are as illustrated in FIG. 3. FIG. 3 illustrates a case of the Al bonding wire having a circular cross-sectional shape. In a case of the Al bonding ribbon having a rectangular or substantially rectangular cross-sectional shape with the width W and the thickness T, the center axis indicates an axis passing through the center of the width W and the center of the thickness T, and the L cross-section indicates a cross section in the center axis direction including the center axis and a cross section in a direction of the thickness T (FIG. 4). Herein, when cross-sectional processing is performed to expose the L cross-section of the Al bonding wire, it may be deviated from the center axis of the Al bonding wire. At this point, if the length of the L cross-section in the direction perpendicular to the center axis is 90% or more of a wire diameter of the Al bonding wire, the cross section can be regarded as a cross section including the center axis.

In an Al alloy containing a high concentration of Si equal to or larger than 3.0% by mass and equal to or smaller than 20.0% by mass, Si exceeding solid solubility of Si is present as Si particles due to crystallization or precipitation. When the Si particles are coarsened, cracks occur at end parts of the Si particles in the high-temperature temperature cycle test, thereby causing a reduction in fatigue resistance of a surface region of the Al bonding wire or the Al bonding ribbon. On the other hand, by controlling the average diameter of the Si phase in the L cross-section to be equal to or larger than 0.8 μm and equal to or smaller than 4 μm, which is a relatively small particle diameter, an effect of enhancing thermal fatigue resistance due to the Si particles in the surface region can be obtained.

In addition to containing 3.0% by mass or more and 20.0% by mass or less of Si, and satisfying, when the Si concentration in the depth direction from the surface is measured by XPS, the above-described characteristic that the ratio Ca/Cb between the average concentration Ca of the Si element in the region a at a depth equal to or larger than 5 nm and equal to or smaller than 50 nm from the surface and the average concentration Cb of the Si element in the region b at a depth equal to or larger than 800 nm and equal to or smaller than 1200 nm from the surface falls within a range equal to or larger than 0.03 and equal to or smaller than 0.5, when the average diameter of the Si phase in the L cross-section falls within a range equal to or larger than 0.8 μm and equal to or smaller than 4 μm, further favorable temperature cycle reliability can be achieved in the high-temperature temperature cycle test. In a case in which the inclination of the Si concentration in a region from the surface to a certain depth and the Si phase having a small particle diameter are included in combination, a synergistic effect relating to control of the bonding interface and reduction of thermal distortion, which are respective effects thereof, can be obtained, whereby the effect of improving temperature cycle reliability can be further enhanced in the high-temperature temperature cycle test. Furthermore, since the Si phase has a lower coefficient of linear thermal expansion than that of Al, the Si phase present in an inner part relative to the surface region has an effect of lowering the coefficient of linear thermal expansion of the entire Al bonding wire or Al bonding ribbon to improve temperature cycle reliability.

From a viewpoint of achieving further favorable temperature cycle reliability in the high-temperature temperature cycle test, the average diameter of the Si phase in the L cross-section of the Al bonding wire or the Al bonding ribbon according to the present invention is more preferably equal to or smaller than 3.8 μm or equal to or smaller than 3.5 μm, still more preferably equal to or smaller than 3.4 μm, equal to or smaller than 3.2 μm, or equal to or smaller than 3 μm, and a lower limit thereof is more preferably equal to or larger than 1 μm, still more preferably equal to or larger than 1.1 μm, and even more preferably equal to or larger than 1.2 μm or equal to or larger than 1.5 μm.

The following describes a method for measuring the average diameter of the Si phase in the L cross-section of the Al bonding wire or the Al bonding ribbon. The average diameter of the Si phase in the L cross-section can be measured by using an SEM-EDS-EBSD apparatus. Specifically, a method of combining information of Al concentration and Si concentration obtained by Scanning Electron Microscope-Energy Dispersive X-ray Spectroscopy (SEM-EDS) and information of a crystal orientation obtained by Electron BackScatter Diffraction (EBSD) can be used. More specifically, in a measurement region designating the L cross-section of the Al bonding wire or the Al bonding ribbon to be an inspection surface, measurement of concentration of Al and Si using the EDS and crystal orientation analysis using the EBSD are performed at the same time. Subsequently, the Al phase and the Si phase are separated and extracted from a measurement result of the EDS by using analysis software attached to the apparatus. Specifically, it is preferable to use Chi Scan function, which is a function of analysis software OIM Data Collection or OIM Analysis (both manufactured by TSL solutions KK) attached to a Field Emission-Scanning Electron Microscope (FE-SEM) apparatus. For a region that is specified as the Si phase, a crystal orientation can be analyzed by using the analysis software attached to the apparatus. If

an orientation difference between measurement points is equal to or larger than 15°, it is determined to be a crystal grain boundary, and an equivalent circle diameter is calculated. An average value of equivalent circle diameters of respective Si phases is defined as the average diameter of the Si phase. In a process of obtaining the average diameter of the Si phase, calculation is performed excluding a part in which the crystal orientation cannot be measured, and a part in which the crystal orientation can be measured but reliability of orientation analysis is low. Thus, in one embodiment, the average diameter of the Si phase in the L cross-section of the Al bonding wire or the Al bonding ribbon according to the present invention is calculated through procedures from (1) to (3) as follows.

(1) The L cross-section of the Al bonding wire or the Al bonding ribbon is designated as the inspection surface, and measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si in a material file.
(3) For the region that is specified as the Si phase, the crystal orientation is analyzed, and if the orientation difference between measurement points is equal to or larger than 15°, it is determined to be the crystal grain boundary, and the equivalent circle diameter of each crystal grain is obtained. An average of equivalent circle diameters of the respective crystal grains is calculated to obtain the average diameter of the Si phase. Herein, regarding average calculation, an average value obtained by Area average (area-weighted average), which can be selected by the software attached to the apparatus, is employed. By employing the average value obtained by Area average, it is possible to accurately measure and determine whether a condition is met, the condition being related to the average diameter of the Si phase and suitable for achieving further favorable temperature cycle reliability in the high-temperature temperature cycle test. In the calculation of Area average, the average value is calculated from an average of values obtained by multiplying a ratio of an area of each particle to areas of all particles by an area value of each particle, which is automatically computed by software.

In the present invention, in calculating the average diameter of the Si phase in the L cross-section, only Si phases having a diameter (equivalent circle diameter) equal to larger than 0.5 μm are considered as targets. Due to this, it is possible to accurately determine whether a requirement is met, the requirement being related to the average diameter of the Si phase in the L cross-section and suitable for achieving further favorable temperature cycle reliability in the high-temperature temperature cycle test.

In the procedure of (2) described above, setting of Tolerance (%) can be selected in a range from 20 to 40%, and about 30% is preferable for comparison in standard analysis of the L cross-section of the Al bonding wire or the Al bonding ribbon. A procedure of adjusting the Tolerance is described supplementarily. It is preferable to select or confirm a numerical value of Tolerance so that the shape and the size of the Si phase extracted and identified by the Chi Scan function are equivalent to the shape and the size of the Si phase identified from an EDS map in which Si element concentration by EDS analysis is two-dimensionally displayed.

In the present invention, the average diameter of the Si phase in the L cross-section is an average value (arithmetic mean) of respective values obtained by measuring at three or more parts. In selecting the measurement region, from a viewpoint of securing objectivity of measurement data, it is preferable to acquire a sample for measurement to be measured from the Al bonding wire or the Al bonding ribbon as a measurement target at intervals of 50 cm or more with respect to the center axis direction of the Al bonding wire or the Al bonding ribbon. In the present invention, the measurement region in the L cross-section measured by the EBSD method is preferably determined so that the length in the center axis direction of the Al bonding wire or the Al bonding ribbon is equal to or larger than 300 μm and smaller than 800 μm, and the entire Al bonding wire or the entire Al bonding ribbon is accommodated therein in a direction perpendicular to the center axis of the Al bonding wire or the Al bonding ribbon, but if the size is large and the entire region is difficult to be measured, it can be adjusted in a range smaller than 600 μm.

Examples of the method for measuring the average diameter of the Si phase include several methods including binarization processing from an observation image of the L cross-section in addition to the methods described above. In the present invention, for possessing the availability of numerous measurement functions, measuring multiple characteristics like the average diameter of the Si phase described above and the orientation ratio of the Al phase described below at one time, the capability for automatic analysis, widely available equipment and analysis techniques, and measuring easily, as described above, it is preferable to employ the method that combines the information on Al and Si concentrations obtained by SEM-EDS with the information on crystal orientations obtained by EBSD.

-Crystal orientation of Al phase in L cross- section-

In the Al bonding wire or the Al bonding ribbon according to the present invention, when the crystal orientation of

the Al phase in the L cross-section is measured, an orientation ratio of a <100> crystal orientation having an angle difference equal to or smaller than 15° with respect to the direction parallel to the center axis (RD direction) (hereinafter, also referred to as an "orientation ratio of the <100> crystal orientation of the Al phase in the RD direction") is preferably equal to or larger than 15% and equal to or smaller than 50%. When the orientation ratio of the <100> crystal orientation of the Al phase in the RD direction falls within the range described above, further favorable bonding strength (1st bonding strength) at an initial stage of bonding at the 1st bonding part can be achieved. This is considered to be because, when ultrasonic vibrations are applied in the RD direction and the Al bonding wire or the Al bonding ribbon is deformed, the <100> crystal orientation having low deformation resistance is oriented in the RD direction, whereby deformation of the bonding interface and metallic bonding can be accelerated.

That is, in addition to containing 3.0% by mass or more and 20.0% by mass or less of Si, and satisfying, when the Si concentration in the depth direction from the surface is measured by XPS, the above-described characteristic that the ratio Ca/Cb between the average concentration Ca of the Si element in the region a at a depth equal to or larger than 5 nm and equal to or smaller than 50 nm from the surface and the average concentration Cb of the Si element in the region b at a depth equal to or larger than 800 nm and equal to or smaller than 1200 nm from the surface falls within a range equal to or larger than 0.03 and equal to or smaller than 0.5, when the orientation ratio of the <100> crystal orientation of the Al phase in the RD direction in the L cross-section falls within a range equal to or larger than 15% and equal to or smaller than 50%, further favorable 1st bonding strength can be achieved. By synergistically obtaining an action of controlling the bonding interface due to the inclination of the Si concentration in a region from the surface to a certain depth and an action caused by orientation of the <100> crystal orientation of the Al phase in the RD direction, an effect of improving the 1st bonding strength can be further enhanced, and as a result, it can also contribute to improvement in temperature cycle reliability in the high-temperature temperature cycle test.

From a viewpoint of achieving further favorable 1st bonding strength, the orientation ratio of the <100> crystal orientation of the Al phase in the RD direction in the L cross-section of the Al bonding wire or the Al bonding ribbon according to the present invention is more preferably equal to or larger than 20%, still more preferably equal to or larger than 22%, equal to or larger than 24%, equal to or larger than 26%, or equal to or larger than 28%, and even more preferably equal to or larger than 30% or equal to or larger than 35%. From a viewpoint of achieving further favorable 1st bonding strength, an upper limit of the orientation ratio of the <100> crystal orientation of the Al phase in the RD direction is more preferably equal to or smaller than 48% or equal to or smaller than 45%, still more preferably equal to or smaller than 42%, and even more preferably equal to or smaller than 40%.

A method to measure the orientation ratio of the crystal orientation of the Al phase in the L cross-section of the Al bonding wire or the Al bonding ribbon is described. The orientation ratio of the crystal orientation of the Al phase in the L cross-section can be measured by using the SEM-EDS-EBSD apparatus similarly to measurement of the average diameter of the Si phase described above. Specifically, a method of combining information of Al concentration and Si concentration obtained by the SEM-EDS and information of a crystal orientation obtained by the EBSD can be used. A more specific procedure is the same as that described above in relation to measurement of the average diameter of the Si phase, that is, the orientation ratio of the <100> crystal orientation of the Al phase in the RD direction can be calculated for a region specified as the Al phase by using the analysis software attached to the apparatus. In calculating the orientation ratio, a partial ratio is used, the partial ratio being calculated by using, as a population, an area of only crystal orientations that have been identified based on certain reliability within a measurement area. Regarding the crystal orientation of the Al phase, an area ratio of the <100> crystal orientation in the RD direction is defined as the orientation ratio of the <100> crystal orientation in the RD direction. Thus, in one embodiment, the orientation ratio of the crystal orientation of the Al phase in the L cross-section of the Al bonding wire or the Al bonding ribbon according to the present invention is calculated through procedures from (1) to (3) as follows.

(1) In the measurement region designating the L cross-section of the Al bonding wire or the Al bonding ribbon to be the inspection surface, measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si in a material file.
(3) For the region specified as the Al phase, the crystal orientation is analyzed, and the orientation ratio of the <100> crystal orientation of the Al phase in the RD direction is calculated.

In measuring the orientation ratio of the crystal orientation of the Al phase in the L cross-section, a setting range of Tolerance in the procedure of (2) described above, a method of acquiring a sample for measurement, and a measurement region of crystal orientation by the EBSD method are the same as those described above regarding measurement of the average diameter of the Si phase.

-Addition of Sr, Na, P, and B-

The Al bonding wire or the Al bonding ribbon according to the present invention may further contain one or more of Sr, Na, P, and B (hereinafter, also referred to as a "first element group"). A total concentration of the first element group may be 0 mass ppm, preferably equal to or larger than 1 mass ppm, more preferably equal to or larger than 3 mass ppm, still more preferably equal to or larger than 5 mass ppm, and particularly preferably equal to or larger than 8 mass ppm or equal to or larger than 10 mass ppm. An upper limit of the total concentration of the first element group is preferably equal to or smaller than 10000 mass ppm or equal to or smaller than 8000 mass ppm, more preferably equal to or smaller than 5000 mass ppm or equal to or smaller than 3000 mass ppm, still more preferably equal to or smaller than 2000 mass ppm or equal to or smaller than 1000 mass ppm, and particularly preferably equal to or smaller than 900 mass ppm or equal to or smaller than 800 mass ppm. In one embodiment, the total concentration of the first element group is preferably equal to or larger than 10 mass ppm and equal to or smaller than 800 mass ppm.

When the Al bonding wire or the Al bonding ribbon according to the present invention further contains 10 mass ppm or more and 800 mass ppm or less of one or more of Sr, Na, P, and B in total, a generation frequency of wire breakage can be reduced in wire-drawing processing for the Al bonding wire or the Al bonding ribbon. In an Al alloy containing a high concentration of Si equal to or larger than 3.0% by mass and equal to or smaller than 20.0% by mass, a frequency of wire breakage in wire-drawing processing tends to be increased. This may be because particles of the Si phase crystallized at the time of solidification cause stress concentration during the wire-drawing processing, and induce wire breakage. It is estimated that stress concentration during wire-drawing can be relieved and wire breakage can be reduced due to effects such that the particulate Si phase may be uniformly distributed, and/or growth and coarsening of the Si phase may be suppressed by adding the first element group.

From a viewpoint of reducing the generation frequency of wire breakage in the wire-drawing processing, the total concentration of the first element group in the Al bonding wire or the Al bonding ribbon according to the present invention is more preferably equal to or larger than 20 mass ppm, and still more preferably equal to or larger than 30 mass ppm, equal to or larger than 40 mass ppm, or equal to or larger than 50 mass ppm, and an upper limit thereof is preferably equal to or smaller than 750 mass ppm, more preferably equal to or smaller than 740 mass ppm, equal to or smaller than 720 mass ppm, or equal to or smaller than 700 mass ppm, still more preferably equal to or smaller than 680 mass ppm, equal to or smaller than 650 mass ppm, equal to or smaller than 620 mass ppm, or equal to or smaller than 600 mass ppm, and particularly preferably equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains one or more elements of the first element group, it may contain any one element of the first element group, may contain any two elements of the first element group, may contain any three elements of the first element group, or may contain all of four elements of the first element group. In a case in which the Al bonding wire or the Al bonding ribbon according to the present invention contains one or more elements of the first element group, it may contain Sr, may contain Na, may contain P, and/or may contain B.

In a case in which the Al bonding wire or the Al bonding ribbon according to the present invention contains Sr of the first element group, a concentration of Sr may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Sr is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Sr is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of Sr is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains Na of the first element group, a concentration of Na may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Na is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Na is preferably equal to or smaller than 10000 mass ppm, equal to or smaller than 8000 mass ppm, equal

to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of Na is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains P of the first element group, a concentration of P may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of P is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of P is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of P is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains B of the first element group, a concentration of B may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of B is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of B is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of B is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

-Addition of Ni, Ti, Fe, Zn, and Mg-

The Al bonding wire or the Al bonding ribbon according to the present invention may further contain one or more of Ni, Ti, Fe, Zn, and Mg (hereinafter, also referred to as a "second element group"). A total concentration of the second element group may be 0 mass ppm, preferably equal to or larger than 1 mass ppm or equal to or larger than 3 mass ppm, more preferably equal to or larger than 5 mass ppm or equal to or larger than 8 mass ppm, still more preferably equal to or larger than 10 mass ppm or equal to or larger than 30 mass ppm, and particularly preferably equal to or larger than 50 mass ppm, equal to or larger than 80 mass ppm, or equal to or larger than 100 mass ppm. An upper limit of the total concentration of the second element group is preferably equal to or smaller than 10000 mass ppm, more preferably equal to or smaller than 8000 mass ppm, still more preferably equal to or smaller than 5000 mass ppm, and particularly preferably equal to or smaller than 3000 mass ppm or equal to or smaller than 2000 mass ppm. In one embodiment, the total concentration of the second element group is preferably equal to or larger than 100 mass ppm and equal to or smaller than 2000 mass ppm.

When the Al bonding wire or the Al bonding ribbon according to the present invention further contains 100 mass ppm or more and 2000 mass ppm or less of one or more of Ni, Ti, Fe, Zn, and Mg in total, generation of scratches and scrapes on the surface of the Al bonding wire or the Al bonding ribbon can be suppressed, and a smooth surface can be formed. In an Al alloy containing a high concentration of Si equal to or larger than 3.0% by mass and equal to or smaller than 20.0% by mass, scratches and scrapes may be generated on a surface thereof during the wire-drawing processing, and may result in the Al bonding wire or the Al bonding ribbon with large surface unevenness when the surface is hardened or the Si phase and Al oxide present on the surface are dropped. It is estimated that scratches and scrapes during the wire-

drawing processing can be reduced by adding the second element group to accelerate stabilization of the Al oxide on the surface of the Al bonding wire or the Al bonding ribbon, refinement and hardening of structures of Al crystal grains, and the like. It is considered that an effect of suppressing generation of scratches and scrapes on the surface of the Al bonding wire or the Al bonding ribbon to form a smooth surface can be enhanced by providing a predetermined inclination in the Si concentration in a region from the surface to a certain depth and adding the second element group thereto.

From a viewpoint of suppressing generation of scratches and scrapes on the surface to form the Al bonding wire or the Al bonding ribbon having a smooth surface, the total concentration of the second element group in the Al bonding wire or the Al bonding ribbon according to the present invention is more preferably equal to or larger than 150 mass ppm, and still more preferably equal to or larger than 200 mass ppm, equal to or larger than 250 mass ppm, or equal to or larger than 300 mass ppm, and an upper limit thereof is preferably equal to or smaller than 1800 mass ppm, more preferably equal to or smaller than 1600 mass ppm, equal to or smaller than 1500 mass ppm, or equal to or smaller than 1200 mass ppm, still more preferably equal to or smaller than 1000 mass ppm, equal to or smaller than 900 mass ppm, or equal to or smaller than 800 mass ppm, and particularly preferably equal to or smaller than 700 mass ppm, equal to or smaller than 600 mass ppm, or equal to or smaller than 500 mass ppm.

In a case in which the Al bonding wire or the Al bonding ribbon according to the present invention contains one or more elements of the second element group, it may contain any one element of the second element group, may contain any two elements of the second element group, may contain any three elements of the second element group, may contain any four elements of the second element group, or may contain all of five elements of the second element group. In a case in which the Al bonding wire or the Al bonding ribbon according to the present invention contains one or more elements of the second element group, it may contain Ni, may contain Ti, may contain Fe, may contain Zn, and/or may contain Mg.

In a case in which the Al bonding wire or the Al bonding ribbon according to the present invention contains Ni of the second element group, a concentration of Ni may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Ni is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Ni is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Ni is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Ti of the second element group, a concentration of Ti may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Ti is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Ti is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Ti is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Fe of the second element group, a concentration of Fe may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Fe is more preferably equal to or larger than 100 mass ppm, and still more preferably equal to or larger than 150 mass ppm, equal to or larger than 200 mass ppm, equal to or larger than 250 mass ppm, or equal to 300 mass ppm. An upper limit of the concentration of Fe is preferably

equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Fe is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Zn of the second element group, a concentration of Zn may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Zn is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Zn is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Zn is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Mg of the second element group, a concentration of Mg may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Mg is more preferably equal to or larger than 100 mass ppm, and still more preferably equal to or larger than 150 mass ppm, equal to or larger than 200 mass ppm, equal to or larger than 250 mass ppm, or equal to 300 mass ppm. An upper limit of the concentration of Mg is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Mg is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

As an aluminum raw material for manufacturing the Al bonding wire or the Al bonding ribbon according to the present invention, it is preferable to use Al having a purity of 4N (Al: 99.99% by mass or more), and more preferable to use Al having a purity of 5N (Al: 99.999% by mass or more) in which an amount of impurities is smaller. In one embodiment, Al having a purity of 3N (Al: 99.9% by mass or more) may be used.

In a range of not inhibiting the effect of the present invention, the Al bonding wire or the Al bonding ribbon according to the present invention may further contain elements other than Al, Si, the first element group, and the second element group (hereinafter, also referred to as "other elements"). That is, the "other elements" mean elements other than Al, Si, Sr, Na, P, B, Ni, Ti, Fe, Zn, and Mg, and the Al bonding wire or the Al bonding ribbon according to the present invention may further contain elements other than Al, Si, Sr, Na, P, B, Ni, Ti, Fe, Zn, and Mg. A total concentration of the other elements in the Al bonding wire or the Al bonding ribbon is not particularly limited in a range of not inhibiting the effect of the present invention. The total concentration of the other elements may be, for example, equal to or smaller than 0.5% by mass, equal to or smaller than 0.4% by mass, equal to or smaller than 0.3% by mass, equal to or smaller than 0.2% by mass, equal to or smaller than 0.15% by mass, equal to or smaller than 0.1% by mass, equal to or smaller than 0.08% by mass, equal to or smaller than 0.06% by mass, equal to or smaller than 0.05% by mass, equal to or smaller than 0.04% by mass, equal to or smaller than 0.03% by mass, equal to or smaller than 0.025% by mass, equal to or smaller than 0.02% by mass, equal to or smaller than 0.018% by mass, equal to or smaller than 0.016% by mass, equal to or smaller than 0.015% by mass, equal to or smaller than 0.014% by mass, equal to or smaller than 0.012% by mass, or equal to or smaller than 0.01% by mass. A lower limit of the total concentration of the other elements is not particularly limited, and may be 0% by mass.

According to one embodiment, a balance of the Al bonding wire or the Al bonding ribbon according to the present

invention consists of Al and the other elements. Thus, according to a preferred embodiment, the Al bonding wire or the Al bonding ribbon according to the present invention consists of Al, Si, and the other elements. According to another preferred embodiment, the Al bonding wire or the Al bonding ribbon according to the present invention consists of Al, Si, one or more elements of the first element group, and the other elements. According to yet another preferred embodiment, the Al bonding wire or the Al bonding ribbon according to the present invention consists of Al, Si, one or more elements of the second element group, and the other elements. According to yet another preferred embodiment, the Al bonding wire or the Al bonding ribbon according to the present invention consists of Al, Si, one or more elements of the first element group, one or more elements of the second element group, and the other elements.

According to one embodiment, a balance of the Al bonding wire or the Al bonding ribbon according to the present invention consists of Al and inevitable impurities. Thus, according to a preferred embodiment, the Al bonding wire or the Al bonding ribbon according to the present invention consists of Al, Si, and inevitable impurities. According to another preferred embodiment, the Al bonding wire or the Al bonding ribbon according to the present invention consists of Al, Si, one or more elements of the first element group, and inevitable impurities. According to yet another preferred embodiment, the Al bonding wire or the Al bonding ribbon according to the present invention consists of Al, Si, one or more elements of the second element group, and inevitable impurities. According to yet another preferred embodiment, the Al bonding wire or the Al bonding ribbon according to the present invention consists of Al, Si, one or more elements of the first element group, one or more elements of the second element group, and inevitable impurities.

According to a preferred embodiment, the Al bonding wire or the Al bonding ribbon according to the present invention does not have a coating that contains a metal other than Al as a main component on an outer periphery of the Al bonding wire or the Al bonding ribbon. Herein, the "coating that contains a metal other than Al as a main component" means the coating in which the content of the metal other than Al is 50% by mass or more.

The Al bonding wire or the Al bonding ribbon according to the present invention may be an Al bonding wire or an Al bonding ribbon. In a case in which the present invention is the Al bonding wire, a wire diameter thereof is not particularly limited, and may be equal to or larger than 50 μm, equal to or larger than 60 μm, equal to or larger than 80 μm, equal to or larger than 100 μm, equal to or larger than 120 μm, equal to or larger than 140 μm, equal to or larger than 150 μm, equal to or larger than 180 μm, or equal to or larger than 200 μm, for example. An upper limit of the wire diameter is not particularly limited, and may be equal to or smaller than 600 μm, equal to or smaller than 550 μm, equal to or smaller than 500 μm, equal to or smaller than 450 μm, or equal to or smaller than 400 μm, for example. In one embodiment, the wire diameter of the Al bonding wire according to the present invention may fall within a range from 100 to 600 μm, and preferably falls within a range from 200 to 400 μm. In a case in which the present invention is the Al bonding ribbon, dimensions (width W × thickness T) of a cross section having a rectangular shape or a substantially rectangular shape are not particularly limited, for example, W may be 100 to 3000 μm and T may be 50 to 600 μm.

The Al bonding wire or the Al bonding ribbon according to the present invention can exhibit excellent temperature cycle reliability even in the high-temperature temperature cycle test. Thus, the Al bonding wire or the Al bonding ribbon according to the present invention can be preferably used as an Al bonding wire or an Al bonding ribbon for a semiconductor device. Particularly, the Al bonding wire or the Al bonding ribbon according to the present invention can be preferably used as an Al bonding wire or an Al bonding ribbon for a power semiconductor device, and can be more preferably used as an Al bonding wire or an Al bonding ribbon for a next-generation power semiconductor device such as a SiC power semiconductor device.

-Method for manufacturing Al bonding wire or Al bonding ribbon-

An example of a method to manufacture the Al bonding wire or the Al bonding ribbon according to the present invention is described. The following describes an example of manufacture of the Al bonding wire.

Al and alloy elements as raw materials preferably have a high purity. Al preferably has a purity of 99.5% by mass or more and includes inevitable impurities as a balance, more preferably has a purity of 99.9% by mass or more and includes inevitable impurities as a balance, and still more preferably has a purity of 99.99% by mass or more and includes inevitable impurities as a balance. Si, the first element group, the second element group, and the other elements used as alloy elements preferably have a purity of 99.9% by mass or more and include inevitable impurities as a balance, and more preferably have a purity of 99.99% by mass or more and include inevitable impurities as a balance. An Al alloy used for the Al bonding wire can be manufactured by loading an Al raw material and raw materials for alloy elements into a crucible made of graphite or alumina that is processed to obtain an ingot having a cylindrical shape, and melting the raw materials by using an electric furnace or a high-frequency heating furnace. A diameter of the ingot having a cylindrical shape is preferably equal to or larger than Φ6 mm and smaller than Φ8 mm while considering processability at a subsequent processing step. An atmosphere in the furnace at the time of melting is preferably an inert atmosphere or a reducing atmosphere to prevent Al, Si, the first element group, the second element group, and the other elements constituting the wire from being excessively oxidized. The highest end-point temperature of melted metal at the time of melting preferably falls within a range equal to or higher than 700°C and lower than 1050°C, considering to facilitate control of the size of the Si

phase at the time of solidification while securing fluidity of the melted metal. As a method for cooling at the time of solidification, water cooling, furnace cooling, air cooling, and the like can be used.

By performing solution treatment to heat an ingot having a cylindrical shape obtained by melting at a high temperature, and repeatedly performing wire-drawing processing using dies thereon, a wire having a desired wire diameter can be manufactured. The wire after being subjected to the wire-drawing processing can be used as an Al bonding wire by performing final heat treatment using the electric furnace.

<Control of inclination of Si concentration>

To control the inclination of the Si concentration in a region from the surface to a certain depth, it is effective to control a wire feeding speed (wire-drawing speed) at a wire-drawing processing step, an area reduction ratio of the die, lubricity at a contact interface between the wire and the die, and an atmosphere of intermediate heat treatment. The following describes an example of manufacturing conditions for providing a predetermined inclination in the Si concentration in the depth direction in a region from the surface to a certain depth (that is, for controlling the ratio Ca/Cb described above to fall within a range equal to or larger than 0.03 and equal to or smaller than 0.5).

-Wire feeding speed-

It is effective for accelerating the concentration inclination to assist deformation of the surface region by controlling the wire feeding speed at a high speed in accordance with a wire diameter for performing wire-drawing processing. As a specific example, it is preferable to set an average of the wire-drawing speed to be equal to or larger than 20 m/min and smaller than 50 m/min at the time of performing wire-drawing processing in a range from a wire diameter of 1/2 with respect to the wire diameter at the time when the wire-drawing processing is started to a final wire diameter.

-Area reduction ratio of dies-

Regarding an area reduction ratio of the die in the wire-drawing processing, drawing a large diameter with a high area reduction ratio and drawing a small diameter with a low area reduction ratio are effective for controlling the concentration inclination. As a specific example, it is preferable that the area reduction ratio of the die from a wire diameter at a start of wire-drawing processing to a wire diameter of 1/2 thereof is set within a range equal to or larger than 20% and smaller than 40%, and the area reduction ratio of the die from the wire diameter of 1/2 to the final wire diameter is set within a range equal to or larger than 10% and smaller than 25%. Herein, defining that the area reduction ratio of the wire per dies is P1, P1 is represented by the following expression.

$$P1 = \{(R_2^2 - R_1^2)/R_2^2\} \times 100$$

In the expression, $R_2$ represents a diameter (mm) of the wire before processing, and $R_1$ represents a diameter (mm) of the wire after processing.

-Lubricity-

By improving lubricity at a contact interface between the wire and the die in the wire-drawing processing and accelerating deformation in which the surface extends in a wire-drawing direction, the concentration inclination of the surface region can be assisted. It is preferable to select, as a lubricating liquid used for the wire-drawing processing, a water-based liquid containing a surfactant or the like that reduces a friction coefficient.

-Atmosphere of intermediate heat treatment-

Adjusting an atmosphere of the intermediate heat treatment is also effective for controlling the concentration inclination of the surface region. The intermediate heat treatment is heat treatment that is performed in the intermediate of a step of performing wire-drawing processing on the ingot until the final wire diameter is obtained. It is preferable to perform the intermediate heat treatment in an atmosphere of an inert gas such as $N_2$ gas. Due to this, it is possible to control oxidation of Si in Al during the wire-drawing processing, and assist in maintaining Si at a low concentration in the vicinity of the surface.

<Control of average diameter of Si phase>

To adjust the average diameter of the Si phase in the L cross-section to fall within a range equal to or larger than 0.8 μm and equal to or smaller than 4 μm, it is effective to adjust a temperature at the time of melting in manufacture of the ingot in a range equal to or higher than 800°C and lower than 1050°C, to adjust a casting temperature in a range equal to or higher than 700°C and lower than 780°C, and to control a temperature for the solution treatment in a range equal to or higher than 450°C and lower than 550°C and control a time for the solution treatment in a range equal to or longer than 1 hour and shorter than 6 hours. The casting temperature is a temperature at the time of casting a melted liquid into a mold and the like, and corresponds to a solidification starting temperature. When the casting temperature is high, the Si phase crystallized at the time of solidification tends to be coarsened and columnarized, and the average diameter of the Si phase tends to be increased. When the temperature for the solution treatment is high, the columnar Si phase is fragmented and granulated, and the average diameter of the Si phase tends to be reduced. To further reduce the average diameter of the Si phase, it is effective to increase a cooling speed at the time of solidification, for example, to perform water cooling.

<Control of orientation ratio of <100> crystal orientation of Al phase in RD direction>

To adjust the orientation ratio of the <100> crystal orientation of the Al phase in the RD direction in the L cross-section to fall within a range equal to or larger than 15% and equal to or smaller than 50%, it is effective to adjust conditions for the intermediate heat treatment. It is effective to set a temperature range for the intermediate heat treatment to be equal to or higher than 250°C and lower than 400°C, and set a time therefor to be equal to or longer than 1 hour and shorter than 48 hours. The number of times of the intermediate heat treatment preferably falls within a range from 2 to 4. It is preferable to perform the intermediate heat treatment at least once in a range from 4.0 to 5.5 times the final wire diameter, and at least once in a range of a wire diameter from 2.0 to 3.5 times the final wire diameter. By performing the intermediate heat treatment under these conditions, processing distortion of the Al phase is reduced and slight recrystallization is caused, thereby reducing a worked structure of the Al phase at the final wire diameter, increasing a degree of progress of recrystallization of the Al phase in subsequent heat treatment, and accelerating rotation of the crystal orientation, whereby adjustment of the orientation ratio of the <100> crystal orientation of the Al phase in the RD direction is facilitated. On the other hand, when the intermediate heat treatment temperature is set to be lower than 250°C or to be equal to or higher than 400°C, there is a concern that the orientation ratio of the <100> crystal orientation of the Al phase in the RD direction becomes unstable.

As the final heat treatment condition, it is effective to adjust a temperature range to be equal to or higher than 200°C and lower than 360°C, and adjust a time within a range equal to or longer than 2 hours and shorter than 24 hours. By the final heat treatment, recovery and recrystallization of the Al phase proceed, and at the same time, an amount of Si dissolved in the Al phase as a solid solution is changed depending on a heat treatment temperature, whereby a recrystallization temperature is changed. By adjusting progress of recrystallization by the final heat treatment, orientation of the crystal orientation can be easily controlled.

As a representative example, the example of manufacture of the Al bonding wire as a wire material has been described above. The Al bonding ribbon as a bar material can also be manufactured basically through the same procedure. As the temperature and the time for the heat treatment, substantially the same conditions as described above can be used. In a case of manufacturing the Al bonding ribbon by rolling processing, an area reduction ratio of a die may be replaced with a rolling reduction ratio to be adjusted.

[Semiconductor device]

The semiconductor device can be manufactured by connecting the electrode on the semiconductor chip to the lead frame or an external electrode on the substrate by using the Al bonding wire or the Al bonding ribbon according to the present invention. That is, the semiconductor device according to the present invention includes the Al bonding wire or the Al bonding ribbon according to the present invention. As described above, wedge bonding is used for both of the 1st bonding with the electrode on the semiconductor chip and the 2nd bonding with the lead frame or the electrode on the substrate.

In one embodiment, the semiconductor device according to the present invention includes a circuit board, the semiconductor chip, and the Al bonding wire or the Al bonding ribbon for bringing the circuit board and the semiconductor chip into conduction with each other, and is characterized in that the Al bonding wire or the Al bonding ribbon is the Al bonding wire or the Al bonding ribbon according to the present invention.

In the semiconductor device according to the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in Japanese Patent Application Laid-open No. 2020-150116, the semiconductor

device may include a lead frame and a semiconductor chip mounted on the lead frame.

Examples of the semiconductor device include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like, and a semiconductor device for electric power (power semiconductor device) is especially preferred.

[Examples]

Hereinafter, the present invention will be described in detail with reference to Examples. However, the present invention is not limited to the following Examples.

[Sample]

A method for producing a sample will be described. As a raw material, Al having a purity of 4N (99.99% by mass or more) and including inevitable impurities as a balance was used. Si, the first element group (Sr, Na, P, B), the second element group (Ni, Ti, Fe, Zn, Mg), and the other elements used as alloy elements each having a purity of 99.99% by mass or more and including inevitable impurities as a balance were also used. The Al alloy used for the Al bonding wire or the Al bonding ribbon was manufactured by loading an Al raw material and raw materials for the alloy elements into an alumina crucible, and melting them by using a high-frequency heating furnace. An atmosphere inside the furnace at the time of melting was an Ar atmosphere, the highest end-point temperature of melted metal at the time of melting was set to be equal to or higher than 700°C and lower than 1050°C, and the casting temperature was set to fall within a range equal to or higher than 700°C and lower than 780°C. The cooling method at the time of solidification was air cooling for performing cooling in the air, or water cooling for performing cooling in water.

After an ingot of Φ6 mm having a cylindrical shape was obtained by melting, and the ingot was subjected to the solution treatment and homogenization processing, wire-drawing processing using dies and intermediate heat treatment were performed to produce an Al bonding wire of Φ300 μm. By using the Al bonding wire of Φ300 μm as a starting raw material, an Al bonding ribbon having a thickness of 100 μm and a width of 600 μm was manufactured by two-stage rolling. A temperature range for the solution treatment was set to be equal to or higher than 450°C and lower than 550°C, and a time therefor was set to be equal to or longer than 1 hours and shorter than 6 hours. Homogenization processing was successively performed in the intermediate of cooling after the solution treatment was ended. The cooling method after the homogenization processing was air cooling for performing cooling in the air.

The intermediate heat treatment was performed two to four times. The intermediate heat treatment was performed at least once in a range from 4.0 to 5.5 times the final wire diameter, and at least once in a range of a wire diameter from 2.0 to 3.5 times the final wire diameter. The intermediate heat treatment was performed by setting a temperature range therefor to be equal to or higher than 250°C and lower than 400°C, and setting a time therefor to be equal to or longer than 1 hour and shorter than 48 hours. The intermediate heat treatment was performed under an $N_2$ gas atmosphere.

During the wire-drawing processing, a commercially available lubricating liquid (water-based lubricating liquid containing a surfactant that reduces a friction coefficient) was used. The area reduction ratio of the wire per die during the wire-drawing processing was set such that the area reduction ratio of the die from the start of the wire-drawing processing to a wire diameter of 3 mm fell within a range equal to or larger than 20% and smaller than 40%, and the area reduction ratio of the die from the wire diameter of 3 mm to the final wire diameter fell within a range equal to or larger than 10% and smaller than 25%. The wire feeding speed during the wire-drawing processing was set within a range equal to or higher than 20 m/min and lower than 50 m/min on average in a range from the wire diameter of 3 mm to the final wire diameter.

A temperature range for the final heat treatment was set to be equal to or higher than 200°C and lower than 360°C, and a time therefor was set to be equal to or longer than 2 hours and shorter than 24 hours.

<Method for measuring Si concentration by X-ray photoelectron spectroscopy (XPS)>

(1) Preparation of measurement sample

A sample of the Al bonding wire or the Al bonding ribbon to be measured was placed on the sample stage. At that time, the position of the sample was adjusted such that the longitudinal direction of the sample of the Al bonding wire or the Al bonding ribbon became a lateral direction on the operation screen of the XPS apparatus. In a case in which the sample was the Al bonding ribbon (having a rectangular cross-sectional shape with the width W of 600 μm and the thickness T of 100 μm), the sample was placed such that a direction of the width W is parallel to a surface of the sample stage and a direction of the thickness T is perpendicular to the surface of the sample stage.

(2) Measurement by XPS

In measurement by XPS, a measurement region was selected such that a vicinity of an apex of the sample of the Al bonding wire or the Al bonding ribbon became the measurement region while viewing a screen of Scanning X-ray Image (SXI) of the apparatus. Under the following conditions, measurement in the depth direction from the surface of the sample of the Al bonding wire was performed by XPS, and spectra of Si2p and Al2p were detected. Peak positions of the spectra of Si2p and Al2p were detected at positions where energy was about 98.5 to 99.5 eV and 71.5 to 73.0 eV, respectively.

- Measurement apparatus: Versa Probe 3 manufactured by ULVAC-PHI, Inc.
- Ultimate vacuum: about $1 \times 10^{-8}$ Torr
- X-ray source: monochromatic Al (1486.6 eV)
- Measurement region: 100 μm (sample longitudinal direction) × 20 μm (sample circumferential direction), rectangular
- Photoelectron extraction angle: 45 degrees
- Detection depth: several nanometers
- Ar sputtering

  Acceleration voltage; 2 kV
  Sputtering region: 2 × 2 mm, rectangular
  Sputtering speed: 9.2 nm/min ($SiO_2$ conversion)

- Analysis pitch in the depth direction: 5 nm pitch (a depth from the surface falls within a range from 0 to 50 nm), 10 nm pitch (a depth from the surface falls within a range from 50 to 200 nm), and 20 nm pitch (a depth from the surface exceeds 200 nm)

(3) Quantification of Si and Al elements

Based on the detected spectra of Si2p and Al2p acquired at respective depth positions in the depth direction from the surface of the sample, quantification of Si and Al elements was performed by the following procedures.

Specifically, quantification of the Si element was performed for a quantification range of energy (about 95.0 to 101.0 eV) that includes a peak of Si0 valence (metallic Si) of Si2p. Depending on the shape of the peak described above, energy values of a low-energy end and a high-energy end were adjusted within the quantification range described above. A background of the quantification range was determined by using Shirley method, and the Si element was quantified based on a peak area obtained by subtracting the background.

Quantitative analysis of the Al element was performed for a quantification range of energy (about 69.0 to 79.0 eV) that includes a peak of Al0 valence (metallic Al) of Al2p, through a procedure similar to that for quantification of the Si element described above.

(4) Calculation of Si concentration

By using quantitative values of Si and Al elements at respective depth positions in the depth direction from the surface of the sample and relative sensitivity coefficients of the respective elements set in the XPS apparatus, the Si concentration was calculated assuming that the sum total of metallic Si and metallic Al at the respective depth positions in the depth direction from the surface of the sample was 100 atom%. An arithmetic mean value of the Si concentration in the region a at a depth equal to or larger than 5 nm and equal to or smaller than 50 nm from the surface was obtained as the average concentration Ca, an arithmetic mean value of the Si concentration in the region b at a depth equal to or larger than 800 nm and equal to or smaller than 1200 nm from the surface was obtained as the average concentration Cb, and an arithmetic mean value of the Si concentration in the region f at a depth equal to or larger than 5 nm and equal to or smaller than 30 nm from the surface was obtained as the average concentration Cf.

In measuring the Si concentration, two samples randomly chosen from some samples obtained from the Al bonding wire or the Al bonding ribbon as a measurement target at intervals of 50 cm or more with respect to the center axis direction of the wire or the ribbon were used. The average concentration Ca, the average concentration Cb, and the average concentration Cf were each defined as an average value (arithmetic mean) of respective values obtained for the two samples through the procedures (1) to (4) described above.

<Method for measuring element content>

For concentration analysis of elements contained in the Al bonding wire or the Al bonding ribbon, Inductively Coupled Plasma-Optical Emission Spectrometer (ICP-OES) ("PS3520UVDDII" manufactured by Hitachi High-Tech

Science Corporation) or Inductively Coupled Plasma-Mass Spectrometer (ICP-MS) ("Agilent 7700x ICP-MS" manufactured by Agilent Technologies, Inc.) was used as an analysis apparatus. By such measurement, concentrations (mass ppm) of respective elements in the entire Al bonding wire or Al bonding ribbon were obtained.

<Method for measuring orientation ratio of crystal orientation of Al phase>

The L cross-section (cross section in the center axis direction including the center axis) of the Al bonding wire or the Al bonding ribbon was designated as the inspection surface, and the crystal orientation of the Al phase was measured.

An FE-SEM (SU-70 manufactured by Hitachi High-Tech Corporation) was used for measurement, and APEX (for data collection) manufactured by TSL solutions KK, OIM Data Collection (for Chi Scan), and OIM Analysis (for data analysis) were used as analysis software. Measurement regions at three parts were randomly selected at intervals of 50 cm or more with respect to the center axis direction of the Al bonding wire or the Al bonding ribbon, and the regions at the three parts were measured. The measurement region was determined so that a size thereof in the center axis direction of the Al bonding wire or the Al bonding ribbon was equal to or larger than 300 μm and smaller than 800 μm, and the entire Al bonding wire or Al bonding ribbon was accommodated therein in the direction perpendicular to the center axis. As a main condition for EDS and EBSD measurement, an acceleration voltage was set to be 15 kV, a measurement magnification was set to be 350-fold, a scan speed was set to be 30 to 120 points/second, and a measurement interval was set to fall within a range from 0.1 to 0.3 μm. Herein, if the scan speed is high, the measurement time can be shortened, but there is concern that measurement accuracy of the EDS may be lowered. It is preferable to select an appropriate scan speed in the range described above.

In measuring the orientation ratio of the crystal orientation of the Al phase in the L cross-section of the Al bonding wire or the Al bonding ribbon, the SEM-EDS-EBSD apparatus was used, and a method of combining information of Al concentration and Si concentration obtained by the SEM-EDS and information of a crystal orientation obtained by the EBSD was used. More specifically, measurement was performed in accordance with procedures from (1) to (3) as follows.

(1) In the measurement region designating the L cross-section of the Al bonding wire or the Al bonding ribbon to be the inspection surface, measurement of concentration of Al and Si using the EDS and crystal orientation measurement using the EBSD were performed at the same time.
(2) Al and Si were separated and extracted by using the Chi Scan function as a function of EBSD analysis software. Specifically, Al and Si were separated and identified by setting Tolerance corresponding to a threshold of Si based on a measurement result of the EDS for Si. The crystal information of Al and Si in the material file was used for analyzing the crystal orientation. Herein, a condition for Tolerance was mainly set to be 30%, and adjusted as needed.
(3) For the region specified as the Al phase, the crystal orientation was analyzed, and the orientation ratio of the <100> crystal orientation of the Al phase in the RD direction was calculated. As crystal orientations to be investigated, at least three types of <111>, <110>, and <100>, which are representative crystal orientations of Al metal, and crystal orientations having high ratios were selected as needed. Herein, as the orientation ratio of the crystal orientation, a partial ratio was used.

The orientation ratio of the <100> crystal orientation of the Al phase in the RD direction was calculated as an average value (arithmetic mean) of respective values obtained for measurement regions at three parts through the procedures from (1) to (3) described above.

<Method for measuring average diameter of Si phase>

In measuring the average diameter of the Si phase in the L cross-section of the Al bonding wire or the Al bonding ribbon, similarly to measurement of the crystal orientation of the Al phase, the SEM-EDS-EBSD apparatus was used, and the method of combining information of Al concentration and Si concentration obtained by the SEM-EDS and information of a crystal orientation obtained by the EBSD was used. Specifically, after performing the procedures (1) and (2) described above, measurement was performed through the procedure (3) as follows. (3) For the region that is specified as the Si phase, the crystal orientation was analyzed, and if the orientation difference between measurement points was equal to or larger than 15°, it was determined to be the crystal grain boundary, and the equivalent circle diameter of each crystal grain was obtained. An average of equivalent circle diameters of the respective crystal grains was calculated to obtain the average diameter of the Si phase. Herein, an average value obtained by Area average (area-weighted average) was used for average calculation. In calculating the average diameter of the Si phase in the L cross-section, only Si phases having a diameter (equivalent circle diameter) equal to or larger than 0.5 μm were considered as targets.

The average diameter of the Si phase was calculated as an average value (arithmetic mean) of respective values obtained for measurement regions at three parts through the procedures from (1) to (3) described above.

[Method for evaluating Al bonding wire or Al bonding ribbon]

The following describes a method for evaluating the Al bonding wire. The wire diameter of the Al bonding wire used for evaluation was Φ300 μm. The semiconductor chip made of Si was used, and as the electrode on the semiconductor chip, used was an alloy having a composition of Al-0.5%Cu deposited to have a thickness of 4 μm. As a substrate, 5 μm of Ni was deposited on an Al alloy. For bonding of the Al bonding wire, a commercially available wire bonder (manufactured by ULTRASONIC ENGINEERING CO., LTD.) was used, and wedge bonding was used for both of the 1st bonding (bonding with the electrode described above on the semiconductor chip) and the 2nd bonding (bonding with the substrate described above). For bonding of the Al bonding ribbon, a fully automatic bonder "BJ955" that is manufactured by Hesse GmbH and equipped with a ribbon bond head was used.

<Method for evaluating high-temperature temperature cycle reliability>

For the high-temperature temperature cycle test (high-temperature TCT), a commercially available thermal shock test apparatus was used. In the high-temperature TCT, a temperature rise and a temperature fall are repeated as a sample chamber moves between a low-temperature tank and a high-temperature tank. A temperature of the low-temperature tank was set to be -40°C, and a temperature of the high-temperature tank was set to be 185°C. The test was started in a state in which the sample chamber was present in the high-temperature tank, and a period from when the sample chamber moved to the low-temperature tank until it returned to the high-temperature tank was defined as one cycle. A time during which the sample chamber stayed in each of the low-temperature tank and the high-temperature tank was set to be 20 minutes. A sample to be subjected to the high-temperature TCT had a structure in which a semiconductor chip was mounted on a substrate, and an electrode on the semiconductor chip was connected with an electrode on the substrate via the Al bonding wire or the Al bonding ribbon. After the test was started, the sample was taken out after 1000 cycles, and a shear test was performed on the 1st bonding part. As a value of shear force of the 1st bonding part used for evaluating the temperature cycle reliability, an average value of shear force of 1st bonding parts at five points, which were randomly extracted, was used. Evaluation was performed based on a force ratio (F2/F1) of a shear force value F2 after the temperature cycle test to a shear force value F1 before the temperature cycle test. If the force ratio was smaller than 50%, it was determined that there was a problem in a practical use and evaluated as "0". If the force ratio was equal to or larger than 50% and smaller than 70%, it was determined that improvement was required and evaluated as "1". If the force ratio was equal to or larger than 70% and smaller than 75%, it was determined to be excellent and evaluated as "2". If the force ratio was equal to or larger than 75%, it was determined to be especially excellent and evaluated as "3". "0" and "1" are unacceptable, and "2" and "3" are acceptable. Evaluation results are described in a column of "High-temperature temperature cycle reliability" in tables.

<Evaluation of high-temperature temperature cycle reliability (after 1300 cycles)>

In the high-temperature TCT described above, the sample was taken out after 1300 cycles of the test, and a shear test was performed on the 1st bonding part. As a value of shear force of the 1st bonding part used for evaluating the temperature cycle reliability, an average value of shear force of 1st bonding parts at five points, which were randomly extracted, was obtained. Evaluation was performed based on a force ratio (F2/F1) of a shear force value F2 after the high-temperature TCT (1300 cycles) to a shear force value F1 before the high-temperature TCT. If the force ratio was smaller than 50%, it was determined that there was a problem in a practical use and evaluated as "0". If the force ratio was equal to or larger than 50% and smaller than 60%, it was determined that there was no problem in a practical use and evaluated as "1". If the force ratio was equal to or larger than 60% and smaller than 70%, it was determined to be excellent and evaluated as "2". If the force ratio was equal to or larger than 70%, it was determined to be especially excellent and evaluated as "3". "0" is unacceptable, and "1", "2", and "3" are acceptable. Evaluation results are described in a column of "High-temperature temperature cycle reliability (after 1300 cycles)" in the tables.

<Method for evaluating 1st bonding strength>

The following describes a method for evaluating the 1st bonding strength. The 1st bonding strength was evaluated by a shear force test. The 1st bonding was performed at ten parts under a bonding condition suitable for a reliability test, and the shear force (shear force) of the 1st bonding part was measured. In this bonding condition, an ultrasonic output was set to be slightly higher to secure a bonding area. For measurement of the shear force, a commercially available micro shear force tester (4000-PLUS manufactured by Nordson Corporation) was used. A shear rate was set to be 200 μm/sec, and a height of a shearing tool was set to be 10 μm from an electrode surface. The shear force was measured by fixing, with a jig, a substrate to which the Al bonding wire or the Al bonding ribbon was bonded. If an average value of the shear force of the 1st bonding parts at ten parts was equal to or larger than 1500 gf, it was determined

to be excellent and evaluated as "3". If the average value of the shear force was equal to or larger than 1300 gf and smaller than 1500 gf, it was determined that there was no problem in a practical use and evaluated as "2". If the average value of the shear force was equal to or larger than 1000 gf and smaller than 1300 gf, it was determined that improvement was required and evaluated as "1". If the average value of the shear force was smaller than 1000 gf, it was determined that there was a problem in a practical use and evaluated as "0". Evaluation results are described in a column of "1st bonding strength" in the tables.

<Method for evaluating wire breakage during processing>

A method for evaluating wire breakage during processing is described. Wire-drawing processing was performed from a wire diameter of 6 mmφ to a wire diameter of 0.3 mmφ, and the number of times of wire breakage was checked. The feeding speed, the area reduction ratio, and the like as processing conditions for wire-drawing are selected from the conditions described above, and appropriate manufacturing conditions are adjusted or changed for each wire. The length of the drawn Al bonding wire fell within a range from 100 to 200 m, and the number of times of wire breakage was calculated in terms of 100 m. If the number of times of wire breakage was 0, it was determined to be favorable and evaluated as "3". If the number of times of wire breakage was 1, it was determined to be able to be handled by improving the manufacturing condition and evaluated as "2". If the number of times of wire breakage was 2 to 4, lowering of productivity was regarded as a problem and evaluated as "1". If the number of times of wire breakage was 5 or more, it was determined that a practical use was difficult to be achieved and evaluated as "0". Evaluation results are described in a column of "Wire breakage during processing" in the tables.

(Method for evaluating scratch and scrape on surface)

A surface property of the Al bonding wire or the Al bonding ribbon was evaluated focusing on scratches and scrapes. The wire diameter of the Al bonding wire was Φ300 μm. Measurement regions at three parts were randomly selected at intervals of 1 m or more with respect to the center axis direction of the Al bonding ribbon or the Al bonding wire, and three samples each having a length of about 2 cm were taken at each of the three parts to observe nine samples in total. Specifically, the surface was observed with magnification in a range from 50-fold to 500-fold using the SEM. A scratch having a length equal to or larger than 50 μm or a scrape having a length equal to or larger than 30 μm were determined to be defects. Parts of scratches and scrapes were counted. If the number thereof was 0, it was determined to be favorable and acceptable, and evaluated as "3". If the number thereof was equal to or larger than 1 and equal to or smaller than 2, it was determined that there was no problem in a practical use and evaluated as "2". If the number thereof was 3 to 7, it was determined that the surface property was not good, and evaluated as "1". If the number thereof was equal to or larger than 8, it was determined that a practical use was difficult to be achieved and evaluated as "0". Evaluation results are described in a column of "Surface property" in the tables.

The evaluation results of Examples and Comparative Examples are indicated in Table 1 to Table 4. Examples 1 to 40 and Comparative Examples 1 to 7 in Table 1 to Table 3 are results related to the Al bonding wire, and Examples B1 to B3 and Comparative Example B1 in Table 4 are results related to the Al bonding ribbon.

[Table 1]

(Table 1)

| | No. | Contained element and concentration | | | | | | | | | | | | | Ratio of Si concentration Ca/Cb | Average diameter of Si phase (μm) | Si concentration Cf (%) | Ratio of <100> of Al phase in RD direction(%) | Evaluation result | | | | |
|---|---|---|---|---|---|---|---|---|---|---|---|---|---|---|---|---|---|---|---|---|---|---|---|
| | | Si (% by mass) | Sr (massppm) | Na (massppm) | P (massppm) | B (massppm) | Ni (massppm) | Ti (massppm) | Fe (massppm) | Zn (massppm) | Mg (massppm) | Other elements (mass ppm) | Total of first element group (mass ppm) | Total of second element group (mass ppm) | | | | | High-temperature cycle reliability | High-temperature cycle reliability (after 1300 cycles) | 1st bonding strength | Wire breakage during processing | Surface property |
| Example | 1 | 3.0 | | | | | | | | | | | 0 | 0 | 0.08 | 0.8 | 0.12 | 31 | 3 | 3 | 3 | 2 | 2 |
| | 2 | 4.5 | | | | | | | | | | | 0 | 0 | 0.03 | 1.8 | 1.47 | 52 | 3 | 3 | 2 | 2 | 2 |
| | 3 | 5.3 | | | | | | | | | | | 0 | 0 | 0.15 | 2.2 | 2.24 | 30 | 3 | 3 | 3 | 2 | 2 |
| | 4 | 6.2 | | | | | | | | | | | 0 | 0 | 0.24 | 4.1 | 3.03 | 22 | 3 | 2 | 3 | 2 | 2 |
| | 5 | 6.8 | | | | | | | | | | | 0 | 0 | 0.16 | 2.6 | 1.80 | 18 | 3 | 3 | 3 | 2 | 2 |
| | 6 | 7.0 | | | | | | | | | | | 0 | 0 | 0.33 | 0.8 | 2.24 | 38 | 3 | 3 | 3 | 2 | 2 |
| | 7 | 7.2 | | | | | | | | | | | 0 | 0 | 0.24 | 2.2 | 2.77 | 47 | 3 | 3 | 3 | 2 | 2 |
| | 8 | 7.4 | | | | | | | | | | | 0 | 0 | 0.32 | 1.1 | 3.21 | 37 | 3 | 3 | 3 | 2 | 2 |
| | 9 | 7.6 | | | | | | | | | | | 0 | 0 | 0.14 | 1.8 | 2.85 | 14 | 3 | 3 | 2 | 2 | 2 |
| | 10 | 8.0 | | | | | | | | | | | 0 | 0 | 0.25 | 2.6 | 3.43 | 27 | 3 | 3 | 3 | 2 | 2 |
| | 11 | 8.5 | | | | | | | | | | | 0 | 0 | 0.27 | 3.1 | 2.96 | 28 | 3 | 3 | 3 | 2 | 2 |
| | 12 | 9.0 | | | | | | | | | | | 0 | 0 | 0.19 | 1.7 | 2.21 | 28 | 3 | 3 | 3 | 2 | 2 |
| | 13 | 10.0 | | | | | | | | | | | 0 | 0 | 0.28 | 2.1 | 2.72 | 13 | 3 | 3 | 2 | 2 | 2 |
| | 14 | 10.2 | | | | | | | | | | | 0 | 0 | 0.50 | 2.8 | 4.34 | 33 | 2 | 2 | 3 | 2 | 2 |
| | 15 | 11.3 | | | | | | | | | | | 0 | 0 | 0.22 | 3.4 | 2.47 | 28 | 3 | 3 | 3 | 2 | 2 |
| | 16 | 12.0 | | | | | | | | | | | 0 | 0 | 0.15 | 2.8 | 3.25 | 32 | 3 | 3 | 3 | 2 | 2 |
| | 17 | 15.3 | | | | | | | | | | | 0 | 0 | 0.24 | 2.5 | 3.88 | 42 | 3 | 3 | 3 | 2 | 2 |
| | 18 | 17.0 | | | | | | | | | | | 0 | 0 | 0.38 | 2.9 | 4.07 | 27 | 3 | 2 | 3 | 2 | 2 |

[Table 2]

(Table 2)

| | No. | Contained element and concentration | | | | | | | | | | | | | Ratio of Si concentration Ca/Cb | Average diameter of Si phase (μm) | Si concentration Cf (%) | Ratio of <100> of Al phase in RD direction(%) | Evaluation result | | | | |
|---|---|---|---|---|---|---|---|---|---|---|---|---|---|---|---|---|---|---|---|---|---|---|---|
| | | Si (% by mass) | Sr (massppm) | Na (massppm) | P (massppm) | B (massppm) | Ni (massppm) | Ti (massppm) | Fe (massppm) | Zn (massppm) | Mg (massppm) | Other elements (mass ppm) | Total of first element group (mass ppm) | Total of second element group (mass ppm) | | | | | High-temperature cycle reliability | High-temperature cycle reliability (after 1300 cycles) | 1st bonding strength | Wire breakage during processing | Surface property |
| Example | 19 | 3.2 | 20 | | | | | | | | | | 20 | 0 | 0.10 | 0.7 | 0.10 | 18 | 3 | 3 | 3 | 3 | 2 |
| | 20 | 7.0 | 150 | | | | | | | | | | 150 | 0 | 0.23 | 2.0 | 1.44 | 31 | 3 | 3 | 3 | 3 | 2 |
| | 21 | 13.2 | 420 | | | | | | | | | | 420 | 0 | 0.38 | 1.8 | 3.84 | 29 | 3 | 3 | 3 | 3 | 2 |
| | 22 | 7.2 | | 170 | | | | | | | | | 170 | 0 | 0.32 | 1.2 | 2.20 | 37 | 3 | 3 | 3 | 3 | 2 |
| | 23 | 5.5 | | | 8 | | | | | | | | 8 | 0 | 0.17 | 2.7 | 1.67 | 32 | 3 | 3 | 3 | 2 | 2 |
| | 24 | 7.0 | | | 156 | | | | | | | | 156 | 0 | 0.31 | 2.3 | 3.13 | 43 | 3 | 3 | 3 | 3 | 2 |
| | 25 | 9.0 | | | | 70 | | | | | | | 70 | 0 | 0.05 | 1.8 | 0.09 | 31 | 3 | 3 | 3 | 3 | 2 |
| | 26 | 6.0 | 120 | | 40 | | | | | | | | 160 | 0 | 0.18 | 2.1 | 2.66 | 21 | 3 | 3 | 3 | 3 | 2 |
| | 27 | 9.5 | 220 | | 116 | 80 | | | | | | Cu: 2210 | 416 | 0 | 0.25 | 1.0 | 2.93 | 19 | 3 | 3 | 3 | 3 | 2 |
| | 28 | 6.0 | | 380 | 280 | 150 | | | | | | | 810 | 0 | 0.33 | 2.0 | 3.25 | 20 | 3 | 3 | 3 | 2 | 2 |
| | 29 | 6.3 | | | | | 70 | | | | | | 0 | 70 | 0.25 | 3.2 | 2.46 | 31 | 3 | 3 | 3 | 2 | 3 |
| | 30 | 4.0 | | | | | | 230 | | | | | 0 | 230 | 0.43 | 2.7 | 4.24 | 29 | 3 | 2 | 3 | 2 | 3 |
| | 31 | 6.0 | | | | | | | 90 | | | | 0 | 90 | 0.27 | 2.6 | 3.02 | 52 | 3 | 3 | 2 | 2 | 2 |
| | 32 | 4.8 | | | | | | | | 330 | | | 0 | 330 | 0.48 | 3.0 | 3.92 | 33 | 2 | 2 | 3 | 2 | 3 |
| | 33 | 6.5 | | | | | | | | | 120 | | 0 | 120 | 0.17 | 2.2 | 2.36 | 35 | 3 | 3 | 3 | 2 | 3 |
| | 34 | 12.8 | | | | | | 100 | | 200 | 70 | | 0 | 370 | 0.25 | 2.9 | 3.20 | 41 | 3 | 3 | 3 | 2 | 3 |
| | 35 | 8.0 | | | | | 232 | | 70 | 420 | | | 0 | 722 | 0.27 | 4.0 | 1.68 | 17 | 3 | 3 | 3 | 2 | 3 |
| | 36 | 7.8 | 120 | | | | | 220 | 120 | | | | 120 | 340 | 0.32 | 1.5 | 2.59 | 26 | 3 | 3 | 3 | 3 | 3 |
| | 37 | 5.5 | | 200 | | 80 | 65 | 300 | | 70 | | Sn: 853 | 280 | 435 | 0.28 | 1.6 | 3.26 | 24 | 3 | 3 | 3 | 3 | 3 |
| | 38 | 6.0 | | | 85 | | 150 | | | 150 | | | 85 | 300 | 0.43 | 3.0 | 4.08 | 14 | 3 | 2 | 2 | 3 | 3 |
| | 39 | 9.0 | 40 | | | 100 | 350 | 820 | 250 | 400 | 220 | | 140 | 2040 | 0.25 | 4.2 | 2.85 | 30 | 3 | 3 | 3 | 3 | 2 |
| | 40 | 6.0 | | | 160 | 120 | | 150 | 110 | | | | 280 | 260 | 0.19 | 2.6 | 1.98 | 27 | 3 | 3 | 3 | 3 | 3 |

[Table 3]

(Table 3)

| | No. | Contained element and concentration | | | | | | | | | | | | | Ratio of Si concentration Ca/Cb | Average diameter of Si phase (μm) | Si concentration Cf (%) | Ratio of <100> of Al phase in RD direction(%) | Evaluation result | | | | |
|---|---|---|---|---|---|---|---|---|---|---|---|---|---|---|---|---|---|---|---|---|---|---|---|
| | | Si (% by mass) | Sr (massppm) | Na (massppm) | P (massppm) | B (massppm) | Ni (massppm) | Ti (massppm) | Fe (massppm) | Zn (massppm) | Mg (massppm) | Other elements (mass ppm) | Total of first element group (mass ppm) | Total of second element group (mass ppm) | | | | | High-temperature cycle reliability | High-temperature cycle reliability (after 1300 cycles) | 1st bonding strength | Wire breakage during processing | Surface property |
| Comparative example | 1 | 0.0 | | | | | | | | | | | 0 | 0 | 0 | 0 | 0.00 | 38 | 0 | 0 | 1 | 2 | 2 |
| | 2 | 2.8 | | | | | | | | | | | 0 | 0 | 0.34 | 0.5 | 0.04 | 45 | 0 | 0 | 0 | 2 | 1 |
| | 3 | 25.3 | | | | | | | | | | | 0 | 0 | 0.44 | 3.8 | 4.40 | 19 | 1 | 1 | 0 | 0 | 0 |
| | 4 | 3.5 | | | | | | | | | | | 0 | 0 | 0.02 | 1.9 | 0.03 | 31 | 1 | 1 | 0 | 1 | 1 |
| | 5 | 8.3 | | | | | | | | | | | 0 | 0 | 0.52 | 3.4 | 3.92 | 27 | 1 | 0 | 0 | 1 | 1 |
| | 6 | 4.2 | | 200 | | | | | | | | | 200 | 0 | 0.02 | 2.7 | 0.12 | 20 | 1 | 1 | 0 | 2 | 1 |
| | 7 | 6.7 | | | | 40 | | 200 | | | 250 | | 40 | 450 | 0.54 | 3.3 | 4.21 | 24 | 1 | 0 | 0 | 2 | 2 |

[Table 4]

(Table 4)

| | No. | Contained element and concentration | | | | | | | | | | | | | Ratio of Si concentration Ca/Cb | Average diameter of Si phase (μm) | Si concentration Cf (%) | Ratio of <100> of Al phase in RD direction(%) | Evaluation result | | | | |
|---|---|---|---|---|---|---|---|---|---|---|---|---|---|---|---|---|---|---|---|---|---|---|---|
| | | Si (% by mass) | Sr (massppm) | Na (massppm) | P (massppm) | B (massppm) | Ni (massppm) | Ti (massppm) | Fe (massppm) | Zn (massppm) | Mg (massppm) | Other elements (mass ppm) | Total of first element group (mass ppm) | Total of second element group (mass ppm) | | | | | High-temperature cycle reliability | High-temperature cycle reliability (after 1300 cycles) | 1st bonding strength | Wire breakage during processing | Surface property |
| Example | B1 | 5.2 | | 44 | | | | | | | | | 44 | 0 | 0.21 | 0.9 | 0.45 | 42 | 3 | 3 | 3 | 2 | 1 |
| | B2 | 8.2 | 106 | | | | | | | | | | 106 | 0 | 0.26 | 1.4 | 1.47 | 33 | 3 | 3 | 3 | 2 | 1 |
| | B3 | 16.3 | 157 | | | 30 | | 85 | 104 | | | | 187 | 189 | 0.09 | 2.1 | 4.26 | 35 | 3 | 2 | 3 | 2 | 2 |
| Comparative example | B1 | 9.4 | | | | | | | | 52 | 112 | | 0 | 164 | 0.58 | 4.2 | 5.22 | 24 | 1 | 1 | 2 | 1 | 2 |

Reference Signs List

1 Al bonding wire
10 center axis
11 L cross-section
2 Al bonding ribbon
20 center axis
21 L cross-section

## Claims

1. An Al bonding wire or an Al bonding ribbon containing 3.0% by mass or more and 20.0% by mass or less of Si, wherein when a Si concentration (atom%) in a depth direction from a surface of the Al bonding wire or the Al bonding ribbon is measured by X-ray photoelectron spectroscopy (XPS), a ratio Ca/Cb between an average concentration Ca of a Si element in a region a at a depth equal to or larger than 5 nm and equal to or smaller than 50 nm from the surface and an average concentration Cb of the Si element in a region b at a depth equal to or larger than 800 nm and equal to or smaller than 1200 nm from the surface is equal to or larger than 0.03 and equal to or smaller than 0.5.

2. The Al bonding wire or the Al bonding ribbon according to claim 1, wherein an average diameter of a Si phase in an L cross-section (cross section in a center axis direction including a center axis) of the Al bonding wire or the Al bonding ribbon is equal to or larger than 0.8 μm and equal to or smaller than 4 μm.

3. The Al bonding wire or the Al bonding ribbon according to claim 1 or 2, wherein an average concentration Cf of the Si element in a region f at a depth equal to or larger than 5 nm and equal to or smaller than 30 nm from the surface is equal to or larger than 0.1 atom% and equal to or smaller than 4 atom%.

4. The Al bonding wire or the Al bonding ribbon according to any one of claims 1 to 3, wherein, when a crystal orientation of an Al phase in the L cross-section (cross section in the center axis direction including the center axis) of the Al bonding wire or the Al bonding ribbon is measured, an orientation ratio of a <100> crystal orientation angled at 15° or less to a direction parallel to the center axis (RD direction) is equal to or larger than 15% and equal to or smaller than 50%.

5. The Al bonding wire or the Al bonding ribbon according to any one of claims 1 to 4, further containing 10 mass ppm or more and 800 mass ppm or less of one or more of Sr, Na, P, and B in total.

6. The Al bonding wire or the Al bonding ribbon according to any one of claims 1 to 5, further containing 100 mass ppm or more and 2000 mass ppm or less of one or more of Ni, Ti, Fe, Zn, and Mg in total.

7. The Al bonding wire or the Al bonding ribbon according to any one of claims 1 to 6, wherein a total concentration of elements other than Al, Si, Sr, Na, P, B, Ni, Ti, Fe, Zn, and Mg in the Al bonding wire or the Al bonding ribbon is equal to or smaller than 0.5% by mass.

8. The Al bonding wire or the Al bonding ribbon according to any one of claims 2 to 7, wherein the average diameter of the Si phase is a value measured by using an SEM-EDS-EBSD apparatus .

9. The Al bonding wire or the Al bonding ribbon according to any one of claims 4 to 8, wherein the orientation ratio of a crystal orientation is a value measured by using an SEM-EDS-EBSD apparatus.

10. The Al bonding wire or the Al bonding ribbon according to any one of claims 1 to 9, used for a semiconductor device.

11. A semiconductor device comprising the Al bonding wire or the Al bonding ribbon according to any one of claims 1 to 10.

[Figure 1]

Si concentration [at. %]
30
25
20
15
10
5
0
Region a
Region b
0
200
400
600
800
1000
1200
1400
Depth(SiO2 conversion) [nm]


[Figure 2]

quantification range
Subpeak of Al
peak of Si2p
strength Counts • s-1
1400
1300
1200
1100
1000
900
800
700
600
500
400
110
108
106
104
102
100
98
96
94
Binding Energy (eV)

[Figure 3]

1
11
RD
10

[Figure 4]

2
21
W
20
RD
T

## INTERNATIONAL SEARCH REPORT

International application No.
**PCT/JP2024/042021**

**A. CLASSIFICATION OF SUBJECT MATTER**

***H01L 21/60***(2006.01)i
FI: H01L21/60 301F

According to International Patent Classification (IPC) or to both national classification and IPC

**B. FIELDS SEARCHED**

Minimum documentation searched (classification system followed by classification symbols)

H01L21/60

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2022/168788 A1 (NIPPON MICROMETAL CORPORATION) 11 August 2022 (2022-08-11) | 1-11 |
| A | JP 1-255232 A (KABUSHIKI KAISHA KOBE SEIKO SHO) 12 October 1989 (1989-10-12) | 1-11 |
| A | WO 2020/184655 A1 (NIPPON MICROMETAL CORPORATION) 17 September 2020 (2020-09-17) | 1-11 |
| A | WO 2022/168787 A1 (NIPPON MICROMETAL CORPORATION) 11 August 2022 (2022-08-11) | 1-11 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **24 January 2025** | **04 February 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/042021**

| Patent document cited in search report | Publication date (day/month/year) | Patent family member(s) | Publication date (day/month/year) |
|---|---|---|---|
| WO 2022/168788 A1 | 11 August 2022 | US 2024/0105668 A1 | |
| | | EP 4289984 A1 | |
| | | CN 116918050 A | |
| | | TW 202239984 A | |
| JP 1-255232 A | 12 October 1989 | (Family: none) | |
| WO 2020/184655 A1 | 17 September 2020 | US 2022/0152749 A1 | |
| | | EP 3940757 A1 | |
| | | CN 113557596 A | |
| | | KR 10-2021-0138019 A | |
| | | TW 202040708 A | |
| WO 2022/168787 A1 | 11 August 2022 | US 2024/0071978 A1 | |
| | | EP 4289983 A1 | |
| | | CN 116918049 A | |
| | | TW 202235634 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2014131010 A
- JP 2014129578 A
- JP 59057440 A
- JP 2020150116 A